# EUROPEAN PATENT APPLICATION

(11) **EP 1 975 987 A2**
(43) Date of publication of application: **01.10.2008**
(21) Application number: 08103209.6
(22) Date of filing: 31.03.2008
(51) Int. Cl.: H01L 21/311, H01L 21/3213, H01L 21/02

(54) **Methods for stripping material for wafer reclamation**

(30) Priority: 31.03.2007 US 909428 P; 13.06.2007 US 943736 P
(71) Applicant: ADVANCED TECHNOLOGY MATERIALS, INC., Danbury, CT 06810 (US)
(72) Inventor: Visintin, Pamela M., New York, CT 12571 (US); Jiang, Ping, Danbury, CT 06810 (US); Korzenski, Michael B., Danbury, CT 06810 (US); King, Mackenzie, Southbury, CT 06488 (US); Fletcher, Kristin A., Danbury, CT 06810 (US); Minsek, David W., New Milford, CT 06776 (US)
(74) Representative: ABG Patentes, S.L.

(57) **Abstract**

Removal compositions and processes for removing at least one material layer from a rejected microelectronic device structure having same thereon. The removal composition includes hydrofluoric acid. The composition achieves substantial removal of the material(s) to be removed while not damaging the layers to be retained, for reclaiming, reworking, recycling and/or reuse of said structure.

## Description

### FIELD OF THE INVENTION

The present invention generally relates to processes useful for the removal of material layers, e.g., low-k dielectrics, from a substrate or article having said material thereon, for reclaiming, reworking, recycling and/or reuse of said substrate or article, and to products manufactured using same.

### DESCRIPTION OF THE RELATED ART

The escalating requirements for performance associated with high density, ultra large scale integration (ULSI) semiconductor wiring have increasingly required the use of low dielectric constant (low-k) insulating layers to increase signal transport speeds as device sizes have decreased.

Typical low-k materials include carbon doped oxides (CDO) deposited using commercially available precursors such as SiLK^{™}, AURORA^{™}, CORAL^{™}, or BLACK DIAMOND^{™}, for example using the proprietary BLACK DIAMOND^{™} process. Such CDO's are typically formed using chemical vapor deposition (CVD) processes from organosilane and organosiloxane precursors. CVD carbon doped oxide low-k dielectrics typically consist of a porous, low density material having an overall dielectric constant less than about 3.2 and are used in a variety of semiconductor structures, typically by forming multiple layers of the CDO's within which other semiconductor structures, such as metal interconnect lines and vias, are formed. For example, CDO's may be used as dielectric insulating layers (inter-metal dielectric (IMD) layers), capping layers and/or as gap filling material for certain structures.

Frequently, a microelectronic device wafer, for example a silicon semiconductor wafer, must be scrapped following the unacceptable processing of a layer during a multi-layer device manufacturing process or qualification process. Any number of processing problems may occur, for example, the non-uniform deposition of a layer or a subsequent etching error. A number of quality control testing methods are performed following selected processing steps whereby the acceptability of the semiconductor wafer may be rejected and "scrapped" for various reasons resulting in a significant non-productive cost. In addition to rejected wafers, test wafers are often scrapped because of the inability to reclaim or recycle certain film types. Test wafer spending is among the top three material expenditures for a fab.

The prior art practice has been to send the rejected or scrapped process wafers to wafer suppliers for processing, whereby a material layer, e.g., dielectric layers such as CDO layers, are removed from the semiconductor wafer using chemical and mechanical methods for reuse of said wafer. Following the successful removal of dielectric layers and other features overlying the wafer, the wafer is recycled or reused in a new multi-layer semiconductor device manufacturing process. As semiconductor wafer manufacturing moves to larger diameter wafers, for example 12 inch wafers, scrapping and recycling a process wafer off-site becomes increasingly more unattractive because of the high non-productive cost.

Improved compositions and processes are disclosed herein whereby at least one material, e.g., metal stack materials, etch stop layers, photoresist, barrier layers, and/or dielectric layers, including high-k and low-k layers, may be removed from microelectronic device structures for reclaiming, reworking, recycling, and/or reuse of said structures, whereby the compositions and processes are compatible with existing manufacturing processes and components. Importantly, the underlying device substrate, e.g., silicon, is preferably undamaged by said removal composition. Preferably, the process of using said compositions to remove materials, e.g., low-k dielectric layers, from the microelectronic devices does not require a high energy-consuming oxidizing step.

In addition to the removal of the material layers while concurrently minimizing the damage to the underlying substrate material, the composition of the invention may be formulated to comply with local environmental requirements. For example, high fluoride concentrations and high organic solvent concentrations may make a composition difficult to use in high volume manufacturing due to wastewater disposal issues. Depending on the level of chemical oxygen demand (COD) of the formulation, whereby the COD of a solution is a measure of the amount of organic compounds that can be fully oxidized to carbon dioxide in the presence of a strong oxidant under acidic conditions, the formulation may not be allowed in the facility wastewater for direct return to the environment. For example, in Switzerland, the COD of a wastewater sample must be reduced to between 200 and 1000 mg/L before wastewater or industrial water can be returned to the environment (Pupunat, L., Sollberger, F., Rychen, P., "Efficient Reduction of Chemical Oxygen Demand in Industrial Wastewaters," http:Hwww.csem.ch/corporate/Report2002/pdf/p56.pdf).

If the wastewater contains only fluoride sources (without organic solvent), a fluoride treatment system may be employed to remove the fluoride from wastewater first, and then the water may be discharged to the environment. If the wastewater contains only organic solvent(s) (without fluoride source), an organic disposal system, such as an incinerator, may be employed. Disadvantageously, incineration systems may not accept wastewater samples containing high fluoride concentrations because the fluoride source may damage the incinerator materials of construction.

Accordingly, in addition to providing an improved composition and process for the removal of at least one material from microelectronic device structures for reclaiming, reworking, recycling, and/or reuse of said structures, the composition and/or process of using said composition preferably complies with local regulatory standards associated with the disposal of said composition.

### SUMMARY OF THE INVENTION

Compositions and processes are disclosed herein, wherein said compositions and processes are useful for the removal of at least one material, e.g., dielectric and/or other material layers, from a microelectronic device structure having said material thereon, for reclaiming, reworking, recycling, and/or reuse of said microelectronic device structure, and methods of using removal compositions and products or intermediate products manufactured using the same.

In one aspect, a removal composition is disclosed, said removal composition comprising at least one etchant, at least one surfactant, optionally at least one organic solvent, optionally at least one chelating agent, optionally at least one oxidizing agent, optionally at least one chloride source and optionally water, wherein said removal composition is suitable for removing at least one material selected from the group consisting of post-etch residue, low-k dielectric, high-k dielectric, etch stop material, metal stack material, barrier layer material, ferroelectric material, silicide material, nitride material, oxide material, photoresist, bottom anti-reflective coating (BARC), sacrificial anti-reflective coating (SARC), polymer-containing buildup, miscellaneous materials, doped regions, and combinations thereof from a microelectronic device structure having said material thereon.

In another aspect, a method of recycling a microelectronic device structure is disclosed, said method comprising:
contacting a microelectronic device structure comprising a microelectronic device substrate and at least one removable material with a removal composition for sufficient time and under sufficient conditions to substantially remove at least one removable material from the microelectronic device structure to yield a reclaimed microelectronic device substrate. The at least one removable material includes, but is not limited to, post-etch residue, low-k dielectric, high-k dielectric, etch stop material, metal stack material, barrier layer material, ferroelectric material, silicide material, nitride material, photoresist, bottom anti-reflective coating (BARC), sacrificial anti-reflective coating (SARC), polymer-containing buildup, miscellaneous materials, and combinations thereof.

In still another aspect, a removal composition is disclosed, said removal composition comprising at least one etchant, at least one surfactant, and optionally water, wherein said removal composition is suitable for removing at least one material selected from the group consisting of post-etch residue, low-k dielectric, high-k dielectric, etch stop material, metal stack material, barrier layer material, ferroelectric material, silicide material, nitride material, oxide material, polymer-containing buildup, miscellaneous materials, doped regions, and combinations thereof from a microelectronic device having said material thereon. Preferably, the at least one etchant comprises HF.

In yet another aspect, a method of recycling a microelectronic device structure is disclosed, said method comprising:
contacting a microelectronic device structure comprising a microelectronic device substrate and at least one removable material selected from the group consisting of post-etch residue, low-k dielectric, high-k dielectric, etch stop material, metal stack material, barrier layer material, ferroelectric material, silicide material, nitride material, oxide material, photoresist, bottom anti-reflective coating (BARC), sacrificial anti-reflective coating (SARC), polymer-containing buildup, miscellaneous materials, doped regions, and combinations thereof, with a removal composition for sufficient time and under sufficient conditions to substantially remove at least one removable material from the microelectronic device structure to yield a reclaimed or reworked microelectronic device structure comprising the microelectronic device substrate and at least one layer to be retained, wherein said retained layer is selected from the group consisting of doped epitaxial Si, undoped epitaxial Si, high-k dielectric, etch stop material, metal stack material, barrier layer material, ferroelectric material, silicide material, nitride material, oxide material, miscellaneous materials, and combinations thereof.

Still another aspect relates to a method of reworking a microelectronic device structure to remove polymer-containing buildup from the backside and/or bevel edge of said structure, said method comprising:
protecting the front side of the structure from contact with a removal composition;
contacting the backside and/or bevel edge of the structure with the removal composition for sufficient time and under sufficient contacting conditions to substantially remove the polymer-containing buildup from the backside and/or bevel edge of the structure.

Another aspect relates to a microelectronic device comprising a microelectronic device substrate and at least one material thereon, wherein said at least one material is selected from the group consisting of low-k dielectric, high-k dielectric, etch stop material, metal stack material, barrier layer material, ferroelectric material, silicide material, nitride material, oxide material, photoresist, bottom anti-reflective coating (BARC), sacrificial anti-reflective coating (SARC), miscellaneous materials, doped regions, and combinations thereof, and wherein the microelectronic device substrate was reclaimed or reworked in a single step using a removal composition.

Still another aspect relates to a method of monitoring the concentration of at least one component in a composition, said method comprising:
sampling said composition at time t = x;
determining the concentration of the at least one component at time t = x;
comparing the concentration of the at least one component at time t = x relative to the concentration of the component at time t = 0; and
adding an aliquot of the component to the composition to increase the concentration of the component.

In another aspect, a method of chemically planarizing a microelectronic device substrate is disclosed, said method comprising exposing said substrate to vapor phase XeF₂ for sufficient time and under sufficient conditions to substantially remove imperfections on the substrate.

Another aspect relates to a method of recycling a microelectronic device substrate, said method comprising:
contacting a microelectronic device structure comprising a microelectronic device substrate and at least two removable materials selected from the group consisting of post-etch residue, low-k dielectric, high-k dielectric, etch stop material, metal stack material, barrier layer material, ferroelectric material, silicide material, nitride material, oxide material, photoresist, bottom anti-reflective coating (BARC), sacrificial anti-reflective coating (SARC), polymer-containing buildup, miscellaneous materials, doped regions, and combinations thereof, with a first removal composition for sufficient time and under sufficient conditions to substantially remove at least a first material from the microelectronic device structure, and
contacting the structure with a second removal composition comprising at least one etchant, at least one surfactant, at least one organic solvent, and water for sufficient time and under sufficient conditions to substantially remove at least a second material from the microelectronic device structure to yield a recyclable or reusable microelectronic device substrate.

Other aspects, features and embodiments of the invention will be more fully apparent from the ensuing disclosure and appended claims.

### BRIEF DESCRIPTION OF THE DRAWINGS

Figure 1A is an electron micrograph of the wafer following immersion in Formulation RR for 10 min at 40°C at 30kx.

Figure 1B is an electron micrograph of the wafer following immersion in Formulation P1 for 10 min at 40°C at 30kx.

Figure 2A is an electron micrograph of the wafer following immersion in Formulation RR for 10 min at 40°C at 100kx.

Figure 2B is an electron micrograph of the wafer following immersion in Formulation P1 for 10 min at 40°C at 100kx.

### DETAILED DESCRIPTION OF THE INVENTION. AND PREFERRED EMBODIMENTS THEREOF

The present invention generally relates to removal compositions and processes useful for the removal of at least one material layer (e.g., dielectric materials (high-k and/or low-k), metal stack materials, etch stop layers, barrier layer materials, silicides, ferroelectrics, photoresist, anti-reflective coatings, post-etch residue, etc.), from a microelectronic device structure having said material thereon, for reclaiming, reworking, recycling and/or reuse of said microelectronic device structure. Said reclaiming, reworking, recycling, and/or reuse may be off-site or in-house.

"Microelectronic device" corresponds to semiconductor substrates, solar cells (photovoltaics), flat panel displays, and microelectromechanical systems (MEMS), manufactured for use in microelectronic, integrated circuit, or computer chip applications. It is to be understood that the terms "microelectronic device," "microelectronic substrate" and "microelectronic device structure" are not meant to be limiting in any way and include any substrate or structure that will eventually become a microelectronic device or microelectronic assembly. The microelectronic device can be patterned, blanketed, a control and/or a test device. A "rejected microelectronic device" structure is intended to capture all microelectronic devices that can be reclaimed, reworked, and/or cleaned according to the methods of the invention.

The "microelectronic device structure" includes a "microelectronic device substrate" with at least one material thereon, where the at least one material is compositionally or crystallographically different than the microelectronic device substrate. As defined herein, "microelectronic device substrate" corresponds to any substrate including, but not limited to: bare silicon; polysilicon; germanium; III/V compounds such as aluminum nitride, gallium nitride, gallium arsenide, indium phosphide; titanites; II/IV compounds; II/VI compounds such as CdSe, CdS, ZnS, ZnSe and CdTe; silicon carbide; sapphire; silicon on sapphire; carbon; doped glass; undoped glass; diamond; GeAsSe glass; poly-crystalline silicon (doped or undoped); mono-crystalline silicon (doped or undoped); amorphous silicon, copper indium (gallium) diselenide; and combinations thereof. The "material" or "material layer(s)" may include, but is/are not limited to, at least one substance selected from the group consisting of doped epitaxial silicon, undoped epitaxial silicon, post-etch residue, low-k dielectric, a high-k dielectric, an etch stop material, a metal stack material, a barrier layer material, a ferroelectric, a silicide, a nitride, an oxide, photoresist, bottom anti-reflective coating (BARC), sacrificial anti-reflective coating (SARC), polymer-containing buildup, miscellaneous materials, doped regions, and combinations thereof. At least one of the material layers may be doped with at least one ion-implanted ion such as boron, phosphorus and arsenic. As defined herein, "miscellaneous materials" include molybdenum-containing materials, lanthanum-containing materials, rhodium-containing materials, manganese-containing materials such as MnOₓ, carbon nanotubes, SrTiO₃, ZrO₂, YVO₄, LiNbO₃, TeO₃, and combinations thereof.

As used herein, "about" is intended to correspond to ± 5 % of the stated value.

As used herein, the term "semi-aqueous" refers to a mixture of water and organic components. The semi-aqueous removal compositions must not substantially damage the layer(s) to be retained located adjacent to the material(s) to be removed using said composition. Depending on the desired results, the "retained layers" may consist of just the microelectronic device substrate (with the doped or undoped epitaxial silicon layer if originally deposited thereon). Alternatively, depending on the desired results, e.g., reclaiming or reworking, "retained layers" may include the microelectronic device substrate as well as at least one material selected from the group consisting of the doped epitaxial silicon, undoped epitaxial silicon, low-k dielectric, a high-k dielectric, an etch stop material, a metal stack material, a barrier layer material, doped regions, a ferroelectric, a silicide, a nitride, an oxide, miscellaneous materials, and combinations thereof. "Not substantially damag[ing] the layer(s) to be retained located adjacent to the material(s) removed" means that less than 100 Å of retained layers are removed, more preferably less than 50 Å, even more preferably less than 20 Å, even more preferably less than 10 Å, and most preferred less than 1 Å of the retained layers are removed using the compositions of the invention. It is to be understood by one skilled in the art that a "layer" may be a blanketed layer or a patterned layer. Notably, the "removable materials/layers" are selected from the group consisting of post-etch residue, low-k dielectric, a high-k dielectric, an etch stop material, a metal stack material, a barrier layer material, a ferroelectric, a silicide, a nitride, an oxide, photoresist, bottom anti-reflective coating (BARC), sacrificial anti-reflective coating (SARC), polymer-containing buildup, miscellaneous materials, doped regions (not including the doped epitaxial layer), and combinations thereof.

As defined herein, "low-k dielectric material" corresponds to any material used as a dielectric material in a layered microelectronic device, wherein the material has a dielectric constant less than about 4.0. Preferably, the low-k dielectric material includes low-polarity materials such as silicon oxide, silicon-containing organic polymers, silicon-containing hybrid organic/inorganic materials, organosilicate glass (OSG), TEOS, fluorinated silicate glass (FSG), SiCOH, and carbon-doped oxide (CDO) glass. For purposes of this invention, low-k dielectric material further includes silicon nitride materials. It is to be appreciated that the low-k dielectric materials may have varying densities and varying porosities.

As defined herein, "metal stack materials" and "metals" correspond to: tantalum, tantalum nitride, titanium nitride, titanium, nickel, cobalt, tungsten, and silicides thereof; copper-containing layers; aluminum-containing layers; Al/Cu layers; alloys of Al;; alloys of Cu; cobalt-containing layers such as CoWP and CoWBP; gold-containing layers; Au/Pt layers; hafnium oxides; hafnium oxysilicates; zirconium oxides; lanthanide oxides; titanates; nitrogen-doped analogues thereof; ruthenium; iridium; cadmium; lead; selenium; silver; MoTa; and combinations and salts thereof on the microelectronic device.

As defined herein, "high-k dielectric" materials correspond to: hafnium oxides (e.g., HfO₂); zirconium oxides (e.g., ZrO₂); hafnium oxysilicates; hafnium silicates; zirconium silicates; titanium silicates; aluminum oxides; lanthanum-doped analogous thereof (e.g., LaAlO₃); aluminum silicates; titanates (e.g., Ta₂O₅); oxides and nitrides of hafnium and silicon (e.g., HfSiON); lanthanum-doped analogues thereof (e.g., HFSiON (La)); barium strontium titanate (BST); oxides of hafnium and aluminum (e.g., HfₓAl_{y}O_{z}); strontium titanate (SrTiO₃); barium titatnate (BaTiO₃); and combinations thereof.

As defined herein, "barrier layer material" corresponds to any material used in the art to seal the metal lines, e.g., copper interconnects, to minimize the diffusion of said metal, e.g., copper, into the dielectric material. Preferred barrier layer materials include silicon-rich nitrides, silicon-rich oxynitrides, tantalum, titanium, ruthenium, hafnium, tungsten, and other refractory metals and their nitrides and silicides.

As defined herein, "ferroelectrics" include, but are not limited to: barium titanate (BaTiO₃); lead titanate (PbTiO₃); lead zirconate titanate (PZT); lead lanthanum zirconate titanate (PLZT); lead magnesium niobate (PMN); Potassium Niobate (KNbO₃); Potassium Sodium Niobate (KₓNa₁₋ₓNbO₃); Potassium Tantalate Niobate (K(TaₓNb₁₋ₓ)O₃); Lead niobate (PbNb₂O₆); bismuth titanate (Bi₄Ti₃O₁₂); lead bismuth niobate (PbBi₂Nb₂O₉); lithium niobate (LiNbO₃); lithium tantalate (LiTaO₃); strontium bismuth tantalate; strontium bismuth tantalate niobate; strontium tantalite; strontium titanate; and combinations and salts thereof.

As defined herein, "etch stop layers" include silicon carbide (SiC), silicon carbon nitride (SiCN), silicon carbon oxide (SiCO), silicon oxynitride (SiON), copper, silicon germanium (SiGe), SiGeB, SiGeC, AlAs, InGaP, InP, InGaAs, and combinations and salts thereof.

As defined herein, "oxides" include any of the oxide compounds defined in the other layers as well as piezoelectrics such as (Pb,Sr)(Zr,Ti)O₃, pyroelectrics such as (Pb,Ca)(Zr,Ti)O₃, superconductors such as YBCO, electrodes such as indium tin oxide, thermal barrier materials such as ZrO₂ CeO₂, Y₂O₃, MgO, Al₂O₃, and SiO₂, optical coatings such as TiO₂, Ta₂O₅, Y₂O₃, and Sc₂O₃, and conductive membranes such as La₍₁₋ₓ₎SrₓGa_{(1-y)}M_{y}O₃ where M = Fe, Co, Ni, La₍₁₋ₓ₎SrₓMnO₃, and La₍₁₋ₓ₎CaₓMnO₃.

As defined herein, "polymer-containing buildup" corresponds to the material that builds up on the backside and the bevel edge of the microelectronic device substrate during manufacturing and includes any of the materials deposited on the microelectronic device to that point including, but not limited to, low-k dielectric, a high-k dielectric, etch stop material, metal stack material, barrier layer material, ferroelectrics, silicides, nitrides, oxides, photoresist, bottom anti-reflective coating (BARC), sacrificial anti-reflective coating (SARC), miscellaneous materials, dopants, and combinations thereof.

As used herein, "reclaiming" the microelectronic device structure corresponds to the substantial removal of at least one material adjacent to a layer(s) to be retained without substantially damaging the layer(s) to be retained, wherein said material(s) to be removed include, but are not limited to, post-etch residue, etch stop-layers, metal stack materials, barrier layer materials, ferroelectrics, silicides, nitrides, oxides, dielectrics (low-k and/or high-k), polymer-containing buildup, doped regions (not including the doped epitaxial layer), and combinations thereof. The layer(s) to be retained are selected from the group consisting of a microelectronic device substrate, doped epitaxial silicon, undoped epitaxial silicon, etch stop-layers, metal stack materials, barrier layer materials, ferroelectrics, silicides, nitrides, dielectrics (low-k and/or high-k), doped regions, and combinations thereof. Reclaiming may be performed off-site or in-house. It is to be appreciated that the material to be removed and the layer to be retained cannot be the same substance. For example, the material to be removed may include low-k dielectric material and the layer to be retained may be the microelectronic device substrate. It is to be appreciated that one skilled in the art, using this disclosure, can determine which composition and process may be used to remove specific materials while retaining specific layers.

As defined herein, "substantial removal" or "substantially remove" corresponds to the removal of at least 90 wt.% of the material(s) desired to be removed, more preferably, at least 95 wt.%, even more preferably, at least 97 wt.%, even more preferably, at least 98 wt.%, and most preferably at least 99 wt.%.

As used herein, "reworking" the microelectronic device structure corresponds to the substantial removal of at least one of photoresist material, anti-reflective coating (ARC), polymer-containing buildup, post-etch residue, electroplated copper, and combinations thereof, subsequent to lithographic development and failure of a quality control test. Alternatively, reworking includes the removal of polymer-containing buildup on the backside and/or bevel edge of the microelectronic device structure. Reworking may be performed off-site or in-house. Subsequent to reworking, the microelectronic device structure may be recoated, baked, and repatterned according to photolithographic techniques known in the art.

As defined herein, an "endpoint" corresponds to a range whereby the removal composition is no longer efficiently and productively removing the materials to be removed from the rejected microelectronic device. The endpoint can be the result of many different factors including, but not limited to, a saturated (e.g., loaded) removal composition, and/or the exhaustion of one or more components of the removal composition.

As defined herein, "recycling" is defined as reclaiming and reusing or reworking and reusing the retained layer(s) of the microelectronic device subsequent to material removal as described herein. For example, the recycled microelectronic device may be reintroduced into the fabrication processing stream, may be used as a control or test device, or may be used in an unrelated process or for an unrelated product.

As defined herein, "substantial elimination" of pitting refers to a decrease in pitting relative to that typically observed using removal compositions known in the art. Preferably, the extent of pitting is less than 10 % of what is observed using other removal compositions, more preferably less than 5%, and most preferably less than 2 %.

It is to be understood that the microelectronic device structure to be reclaimed includes a substrate selected from the group consisting of bare silicon; polysilicon; germanium; III/V compounds such as gallium nitride, gallium arsenide, indium phosphide; titanites; If/IV compounds; II/VI compounds such as CdSe, CdS, ZnS, ZnSe and CdTe; silicon carbide; sapphire; silicon on sapphire; carbon; doped glass; undoped glass; diamond; GeAsSe glass; and combinations thereof, and can be any diameter or thickness conventionally used in the art. For example, substrate diameters conventionally used in the art include 200 mm, 300 mm, 4 inch, 6 inch, and in the future 450 mm. A 300 mm substrate has a thickness of 750 µm, and the thickness of the other substrates is directly proportional to the diameter relative to the 300 mm substrate.

The requirements of a successful reclamation include, but are not limited to, zero or negligible front-side, bevel edge, and/or backside silicon pitting; less than 25 particles at 0.25 µm, less than 50 particles at 0.12 µm, or less than 100 particles at 0.09 µm, a total thickness variation (TTV) of less than about 5 µm, a surface metal contamination of less than 1 × 10¹⁰ atoms cm⁻²; and/or the thickness of a reclaimed substrate (devoid of any other retained layers) is within 5 %, preferably within 2%, and most preferably within 1 %, of the thickness of the original substrate. As defined herein, "total thickness variation" corresponds to the absolute difference between the maximum and the minimum thickness of a microelectronic device wafer as determined using a thickness scan or series of point thickness measurements known in the art.

The requirements of a successful wafer rework include, but are not limited to, the substantial removal of photoresist, polymeric-containing buildup, and/or electroplated copper from the outermost edge and backside of the device substrate without substantial damage to the layer(s) to be retained, which reduces particle and metal contamination during subsequent processing.

### The Removal Compositions

Removal compositions may be embodied in a wide variety of specific formulations, as hereinafter more fully described.

In all such compositions, wherein specific components of the composition are discussed in reference to weight percentage ranges including a zero lower limit, it will be understood that such components may be present or absent in various specific embodiments of the composition, and that in instances where such components are present, they may be present at concentrations as low as 0.001 weight percent, based on the total weight of the composition in which such components are employed.

In a first aspect, removal compositions are disclosed that are useful in removing one or more of post-etch residue, low-k dielectric, high-k dielectric, barrier layer material, ferroelectrics, nitrides, silicides, oxides, photoresist, polymer-containing material, ARC material, doped regions and/or miscellaneous materials from the surface of a microelectronic device structure for reclaiming or reworking of said microelectronic device substrate, and methods of making and using the same. The removal compositions of the first aspect will also usefully remove SiCN. The compositions of the first aspect may comprise, consist of or consist essentially of an etchant source, wherein the etchant source is preferably a fluoride source such as hydrofluoric acid (HF).

In one embodiment of the first aspect, the compositions may comprise, consist of, or consist essentially of at least one amine species, at least one etchant, optionally at least one organic solvent, optionally at least one additional acid species, optionally at least one chelating agent, and optionally water, present in the following ranges, based on the total weight of the composition:

| component | % by weight |
|---|---|
| amine(s) | about 0.1% to about 70.0% |
| etchant(s) | about 0.01% to about 70.0% |
| optional organic solvent(s) | 0 to about 80.0% |
| optional additional acid(s) | 0 to about 80% |
| optional chelating agent(s) | 0 to about 10% |
| optional water | 0 to about 90% |

In general, the specific proportions and amounts of amine(s), etchant source(s), optional organic solvent(s), optional additional acid(s), optional chelating agent(s), and optional water, in relation to each other, may be suitably varied to provide the desired removal action of the composition for the material(s) to be removed and/or processing equipment, as readily determinable within the skill of the art without undue effort.

Compositions of the first aspect have a pH value in a range from about 1 to about 7, more preferably about 2.5 to about 4.5, most preferably about 3 to about 3.5, when diluted 20:1 with deionized water.

The etchant may include, but is not limited to, fluorides, amines, and/or hydroxide salts including at least one of: hydrogen fluoride (HF); xenon difluoride (XeF₂); ammonium fluoride (NH₄F); tetraalkylammonium fluoride (NR₄F); alkyl hydrogen fluoride (NRH₃F); ammonium hydrogen bifluoride (NH₅F₂); dialkylammonium hydrogen fluoride (NR₂H₂F); trialkylammonium hydrogen fluoride (NR₃HF); trialkylammonium trihydrogen fluoride (NR₃:3HF); anhydrous hydrogen fluoride pyridine complex; anhydrous hydrogen fluoride triethylamine complex; amine hydrogen fluoride complexes, where R may be the same as or different from one another and is selected from the group consisting of straight-chained or branched C₁-C₆ alkyl groups (e.g., methyl, ethyl, propyl, butyl, pentyl, hexyl) and where the amine includes straight-chained or branched C₁-C₂₀ alkylamines, substituted or unsubstituted C₆-C₁₀ arylamines, glycolamines, alkanolamines, and amine-N-oxides including, but not limited to: pyridine; 2-ethylpyridine; 2-methoxypyridine and derivatives thereof such as 3-methoxypyridine; 2-picoline; pyridine derivatives; dimethylpyridine; piperidine; piperazine; triethylamine; triethanolamine; ethylamine, methylamine, isobutylamine, tert-butylamine, tributylamine, dipropylamine, dimethylamine, diglycol amine; monoethanolamine; pyrrole; isoxazole; 1,2,4-triazole; bipyridine; pyrimidine; pyrazine, pyridazine; quinoline; isoquinoline; indole; imidazole; N-methylmorpholine-N-oxide (NMMO); trimethylamine-N-oxide; triethylamine-N-oxide; pyridine-N-oxide; N-ethylmorpholine-N-oxide; N-methylpyrrolidine-N-oxide; N-ethylpyrrolidine-N-oxide; 1-methylimidazole; diisopropylamine; diisobutylamine; aniline; aniline derivatives; and combinations thereof. Alternatively, the etchant may comprise a hydroxide salt including, but not limited to, an alkali hydroxide, an alkaline earth metal hydroxide, a quaternary amine hydroxide, and combinations thereof. Preferably, the etchant comprises hydrogen fluoride.

The amine species may include, but are not limited to, straight-chained or branched C₁-C₂₀ alkylamines, substituted or unsubstituted C₆-C₁₀ arylamines, glycolamines, alkanolamines, and amine-N-oxides including, but not limited to, pyridine; 2-ethylpyridine; 2-methoxypyridine and derivatives thereof such as 3-methoxypyridine; 2-picoline; pyridine derivatives; dimethylpyridine; piperidine; piperazine; triethylamine; triethanolamine; ethylamine; methylamine; isobutylamine; tert-butylamine; tributylamine; dipropylamine; dimethylamine; diglycol amine; monoethanolamine; pyrrole; isoxazole; 1,2,4-triazole; bipyridine; pyrimidine; pyrazine; pyridazine; quinoline; isoquinoline; indole; imidazole; N-methylmorpholine-N-oxide (NMMO); trimethylamine-N-oxide; triethylamine-N-oxide; pyridine-N-oxide; N-ethylmorpholine-N-oxide; N-methylpyrrolidine-N-oxide; N-ethylpyrrolidine-N-oxide; 1-methylimidazole; diisopropylamine; diisobutylamine; aniline; aniline derivatives; polyamines; and combinations thereof. Preferably, the amine species comprises isoxazole, TAZ, or combinations thereof.

Alternatively, the amine species may comprise a combined amine-hydrogen fluoride salt. Accordingly, the removal compositions of the first aspect may include at least one amine-hydrogen fluoride salt, optionally at least one organic solvent, optionally at least one organic acid, optionally at least one chelating agent, and optionally water. Amine-hydrogen fluoride salts are non-volatile and as such, changes in the solution pH due to evaporation of the amine species is avoided. Amine-hydrogen fluoride salts contemplated herein include, but are not limited to, any of the above-enumerated amines in combination with HF to form an amine-hydrogen fluoride salt. Preferably, the amine-hydrogen fluoride salt species, when used, comprises isoxazole:HF and/or NMMO:HF. It is to be appreciated that the mole ratio of amine:hydrogen fluoride salt may vary from about 1:1 to about 20:1 depending on the conditions of the reaction and the nature of the low-k dielectric material to be removed.

Water may be included in the compositions of the first aspect in part because of its ability to solubilize the fluoride species. Preferably, the water is deionized.

The organic solvent(s), when present, serve as a solvent, assist in the penetration and dissolution of organic residues, wet the surface of the microelectronic device structure to facilitate material removal and/or passivate the underlying adjacent materials (e.g., the microelectronic device substrate). Organic solvents contemplated herein include, but are not limited to, alcohols, ethers, pyrrolidinones, glycols, carboxylic acids, glycol ethers, amines, ketones, aldehydes, alkanes, alkenes, alkynes, and amides, more preferably alcohols, ethers, pyrrolidinones, glycols, carboxylic acids, and glycol ethers such as methanol, ethanol, isopropanol, butanol, and higher alcohols (including diols, triols, etc.), 2,2,3,3,4,4,5,5-octafluoro-1-pentanol, 1H,1H,9H-perfluoro-1-nonanol, perfluoroheptanoic acid, 1H,1H,7H-dodecafluoro-1-heptanol, perfluoropentanoic acid, 1H,1H,8H,8H-dodecafluoro-1,8-octanediol, 2,2,3,3,4,4,5,5-octafluoro-1,6-hexanediol, 5H-perfluoropentanoic acid, n-butyl heptafluorobutyrate, tetrahydrofuran (THF), N-methylpyrrolidinone (NMP), cyclohexylpyrrolidinone, N-octylpyrrolidinone, N-phenylpyrrolidinone, methyl formate, dimethyl formamide (DMF), dimethylsulfoxide (DMSO), tetramethylene sulfone (sulfolane), diethyl ether, phenoxy-2-propanol (PPh), propriopheneone, ethyl lactate, ethyl acetate, ethyl benzoate, acetonitrile, acetone, ethylene glycol, propylene glycol, dioxane, butyryl lactone, butylene carbonate, ethylene carbonate, propylene carbonate, dipropylene glycol, amphiphilic species (diethylene glycol monomethyl ether, triethylene glycol monomethyl ether, diethylene glycol monoethyl ether, triethylene glycol monoethyl ether, ethylene glycol monopropyl ether, ethylene glycol monobutyl ether, diethylene glycol monobutyl ether (i.e., butyl carbitol), triethylene glycol monobutyl ether, ethylene glycol monohexyl ether, diethylene glycol monohexyl ether, ethylene glycol phenyl ether, propylene glycol methyl ether, dipropylene glycol methyl ether, tripropylene glycol methyl ether, dipropylene glycol dimethyl ether, dipropylene glycol ethyl ether, propylene glycol n-propyl ether, dipropylene glycol n-propyl ether (DPGPE), tripropylene glycol n-propyl ether, propylene glycol n-butyl ether, dipropylene glycol n-butyl ether, tripropylene glycol n-butyl ether, propylene glycol phenyl ether, and combinations thereof), branched fluorinated or non-fluorinated ether-linkage carboxylic acids (CH₃CH₂)ₙO(CH₂)ₘCOOH, where n = 1 to 10 and m = 1 to 10), unbranched fluorinated or non-fluorinated ether-linkage carboxylic acids (CH₃CH₂)ₙO(CH₂)ₘCOOH, where n = 1 to 10 and m = 1 to 10), branched fluorinated or non-tluorinated non-ether linkage carboxylic acids (CH₃(CH₂)ₙCOOH, where n = 1 to 10), unbranched fluorinated or non-fluorinated non-ether linkage carboxylic acids (CH₃(CH₂)ₙCOOH, where n = 1 to 10), dicarboxylic acids, tricarboxylic acids, and combinations thereof. In addition, the solvent may comprise other amphiphilic species, i.e., species that contain both hydrophilic and hydrophobic moieties similar to surfactants. Hydrophobic properties may generally be imparted by inclusion of a molecular group consisting of hydrocarbon or fluorocarbon groups and the hydrophilic properties may generally be imparted by inclusion of either ionic or uncharged polar functional groups. Preferably, the organic solvent comprises sulfolane, butyl carbitol, dipropylene glycol propyl ether, or mixtures thereof.

The optional additional acid(s) assist in breaking up and solubilizing the cross-linked polymer bonds in the low-k dielectric material. The additional acids may be organic and/or inorganic and include, but are not limited to, boric acid, oxalic acid, succinic acid, citric acid, lactic acid, acetic acid, trifluoroacetic acid, tetrafluoroboric acid, hydrofluoric acid, hydrochloric acid, formic acid, fumaric acid, acrylic acid, malonic acid, maleic acid, malic acid, L-tartaric acid, methyl sulfonic acid, trifluoromethanesulfonic acid, iodic acid, mercaptoacetic acid, thioacetic acid, glycolic acid, sulfuric acid, nitric acid, propynoic acid, pyruvic acid, acetoacetic acid, and combinations thereof.

Chelating agent(s) may be added to reduce or eliminate metal contaminating species on the surface of the device during wafer reclamation. Chelating agent(s) contemplated herein include, but are not limited to: β-diketonate compounds such as acetylacetonate, 1,1,1-trifluoro-2,4-pentanedione, and 1,1,1,5,5,5-hexafluoro-2,4-pentanedione; carboxylates such as formate and acetate and other long chain carboxylates; and amides (and amines), such as bis(trimethylsilylamide) tetramer. Additional chelating agents include amines and amino acids (i.e. glycine, serine, proline, leucine, alanine, asparagine, aspartic acid, glutamine, valine, and lysine), citric acid, acetic acid, maleic acid, oxalic acid, malonic acid, succinic acid, phosphonic acid, phosphonic acid derivatives such as hydroxyethylidene diphosphonic acid (HEDP), 1-hydroxyethane-I,I-diphosphonic acid, nitrilo-tris(methylenephosphonic acid), nitrilotriacetic acid, iminodiacetic acid, etidronic acid, ethylenediamine, ethylenediaminetetraacetic acid (EDTA), and (1,2-cyclohexylenedinitrilo)tetraacetic acid (CDTA), uric acid, tetraglyme, pentamethyldiethylenetriamine (PMDETA), 1,3,5-triazine-2,4,6-thithiol trisodium salt solution, 1,3,5-triazine-2,4,6-thithiol triammonium salt solution, sodium diethyldithiocarbamate, disubstituted dithiocarbamates (R¹(CH₂CH₂O)₂NR²CS₂Na) with one alkyl group (R² = hexyl, octyl, deceyl or dodecyl) and one oligoether (R¹(CH₂CH₂O)₂, where R¹ = ethyl or butyl), ammonium sulfate, monoethanolamine (MEA), Dequest 2000, Dequest 2010, Dequest 2060s, diethylenetriamine pentaacetic acid, propylenediamine tetraacetic acid, 2-hydroxypyridine 1-oxide, ethylendiamine disuccinic acid, sodium triphosphate penta basic, and combinations thereof. Unlike non-fluorinated beta-diketones, which may need to be combined with a base to form a deprotonated compound capable of chelation, fluorinated beta-diketone chelating agents can be used in the absence of a base. The chelating agent may be introduced to the composition at the manufacturer, prior to introduction of the composition to the device wafer, or alternatively at the device wafer, i.e., *in situ.* It is further contemplated that in addition to chelating agent(s), other components may be added to the composition to dilute, maintain and/or increase the concentration of other components in the composition.

Such compositions may optionally include additional components, including active as well as inactive ingredients, e.g., surfactants, rheology agents, stabilizers, passivators, dispersants, pH stabilizing agents, oxidants, etc. For example, about 0.01 wt. % to about 10 wt. % surfactant may be added to the removal composition of the first aspect of the invention. Surfactants contemplated include nonionic, anionic, cationic (based on quaternary ammonium cations) and/or zwitterionic surfactants. For example, suitable non-ionic surfactants may include fluoroalkyl surfactants, ethoxylated fluorosurfactants, polyethylene glycols, polypropylene glycols, polyethylene or polypropylene glycol ethers, carboxylic acid salts, dodecylbenzenesulfonic acid or salts thereof, polyacrylate polymers, dinonylphenyl polyoxyethylene, silicone or modified silicone polymers, acetylenic diols or modified acetylenic diols, alkylammonium or modified alkylammonium salts, and alkylphenol polyglycidol ether, as well as combinations comprising at least one of the foregoing. In a preferred embodiment, the nonionic surfactant may be an ethoxylated fluorosurfactant such as ZONYL® FSO-100 fluorosurfactant (DuPont Canada Inc., Mississauga, Ontario, Canada). Anionic surfactants contemplated in the compositions of the present invention include, but are not limited to, fluorosurfactants such as ZONYL® UR and ZONYL® FS-62 (DuPont Canada Inc., Mississauga, Ontario, Canada), sodium alkyl sulfates such as sodium ethylhexyl sulfate (NIAPROOF® 08), ammonium alkyl sulfates, alkyl (C₁₀-C₁₈) carboxylic acid ammonium salts, sodium sulfosuccinates and esters thereof, e.g., dioctyl sodium sulfosuccinate, alkyl (C₁₀-C₁₈) sulfonic acid sodium salts, and the di-anionic sulfonate surfactants DowFax (The Dow Chemical Company, Midland, Mich., USA). Cationic surfactants contemplated include alkylammonium salts such as cetyltrimethylammonium bromide (CTAB) and cetyltrimethylammonium hydrogen sulfate. Suitable zwitterionic surfactants include ammonium carboxylates, ammonium sulfates, amine oxides, N-dodecyl-N,N-dimethylbetaine, betaine, sulfobetaine, alkylammoniopropyl sulfate, and the like. Alternatively, the surfactants may include water soluble polymers including, but not limited to, polyethylene glycol (PEG), polyethylene oxide (PEO), polyvinyl pyrrolidone (PVP), cationic polymers, nonionic polymers, anionic polymers, hydroxyethylcellulose (HEC), acrylamide polymers, poly(acrylic acid), carboxymethylcellulose (CMC), sodium carboxymethylcellulose (Na CMC), hydroxypropylmethylcellulose, polyvinylpyrrolidone K30, BIOCARE^{™} polymers, DOW^{™} latex powders (DLP), ETHOCEL^{™} ethylcellulose polymers, KYTAMER^{™} PC polymers, METHOCEL^{™} cellulose ethers, POLYOX^{™} water soluble resins, SoftCAT^{™} polymers, UCARE^{™} polymers, UCON^{™} fluids, and combinations thereof. The water soluble polymers may be short-chained or long-chained polymers and may be combined with the nonionic, anionic, cationic, and/or zwitterionic surfactants of the invention. When surfactants are included in the compositions of the invention, preferably defoaming agents are added in a range from 0 to 5 wt. %, based on the total weight of the composition. Defoaming agents contemplated include, but are not limited to, fatty acids, alcohols (simple or polyol) and amines such as caprylic acid diglyceride, lecithin, magnesium carbonate, polyethylene homopolymers and oxidised homopolymer M3400 , dimethopolysiloxane-based, silicone-based, AGITAN^{™}, and fatty acid polyether types such as LUMITEN^{™}, oils, and combinations thereof.

Specific embodiments of the first aspect of the removal composition may be in concentrated form and include the following, wherein the components may be present in the following ranges, based on the total weight of the composition:

| component | % by weight | preferred/% by weight |
|---|---|---|
| amine(s) | about 1% to about 30.0% | about 5% to about 20.0% |
| hydrofluoric acid | about 5% to about 60.0% | about 15% to about 30.0% |
| organic solvent(s) | about 5% to about 98% | about 25% to about 70% |
| additional acid(s) | about 5% to about 35% | about 10% to about 30% |
| water | about 0.01 % to about 50% | about 0.01 to about 50% |

or

| component | % by weight | preferred/% by weight |
|---|---|---|
| amine-hydrogen fluoride salt | about 1 % to about 40.0% | about 5% to about 30.0% |
| hydrofluoric acid | about 0.01 % to about 5.0% | about 1% to about 32% |
| organic solvent(s) | about 40% to about 90% | about 50% to about 85% |
| additional acid(s) | about 1% to about 20% | about 5% to about 20% |
| water | about 0.01 % to about 50% | about 0.01 % to about 50% |

or

| component | % by weight | preferred/% by weight |
|---|---|---|
| amine-hydrogen fluoride salt | about 1% to about 40.0% | about 30% to about 35.0% |
| hydrofluoric acid | about 0.01% to about 5.0% | about 1% to about 2% |
| organic solvent(s) | about 45% to about 99% | about 55% to about 70% |
| water | about 0.01% to about 25% | about 0.01 % to about 25% |

or

| component | % by weight | preferred/% by weight |
|---|---|---|
| amine | about 1% to about 60% | about 20% to about 40% |
| hydrofluoric acid | about 40% to about 99% | about 35% to about 45% |
| water | about 0.01 % to about 50% | about 0.01 % to about 50% |

or

| component | % by weight | preferred/% by weight |
|---|---|---|
| amine | about 1 % to about 30.0% | about 5% to about 25% |
| hydrofluoric acid | about 5% to about 60% | about 15% to about 50% |
| organic solvent(s) | about 1% to about 80% | about 30% to about 75% |
| water | about 0.01% to about 80% | about 0.01% to about 70% |

or

| component | % by weight | preferred/% by weight |
|---|---|---|
| amine | about 0.1 to about 50% | about 5% to about 35% |
| hydrofluoric acid | about 10% to about 75% | about 15% to about 70% |
| water | about 0.01 % to about 90°% | about 0.01 % to about 90% |

and the pH of a 20:1 dilution of the removal composition in deionized water is in a range from about 2.5 to about 4.5. Preferably, the removal composition of the first aspect contains less than 30 wt. %, preferably less than 10 wt%, more preferably less than 2wt%, even more preferably less than 1 wt% and most preferred is devoid of tetrahydrofurfuryl alcohol. In the broad practice of the invention, the removal composition of the first aspect may comprise, consist of, or consist essentially of any of the foregoing embodiments.

In one embodiment of the first aspect, the removal composition is used to reclaim the microelectronic device structure. In other words, one removable layer or more than one removable layer may be removed from the microelectronic device structure.

In another embodiment of the first aspect, the removal composition may be used to rework the microelectronic device structure, whereby the polymer-containing buildup on the backside and/or bevel edge of the structure is removed. Importantly, the process of removing the polymer-containing buildup from the backside and/or bevel edge of the structure may, but not necessarily, require protecting the front-side of the structure from exposure to the composition. Such a process may include the positioning of the structure in a single wafer tool that protects the front side of the wafer using an inert gas, e.g., nitrogen, and/or a deionized water spray. Alternatively, the front side may be protected by depositing a thick layer of photoresist or other protective coating polymer on the front side. In other words, if the front side of the structure includes patterned and/or blanketed material(s) that should not be exposed to the removal composition of the first aspect when cleaning the backside and/or bevel edge, the front side should be protected. In another embodiment, both the front side and the backside/bevel edge is exposed to the removal composition of the first aspect to simultaneously remove material from the front side (e.g., low-k dielectric material, etc.) and the backside/bevel edge (e.g., polymer-containing buildup and copper-containing material).

Further, the foregoing embodiments of the removal composition of the first aspect may further include residue material, wherein said residue material includes post-etch residue, low-k dielectric, high-k dielectric, barrier layer material, ferroelectric, nitride, silicide, oxide, photoresist, polymer-containing material, ARC material, doped regions and/or miscellaneous material residue. In one embodiment, the removal composition includes at least one amine species, hydrofluoric acid, water, material residue, optionally at least one organic solvent, optionally at least one chelating agent, and optionally at least one additional acid species. In another embodiment, the removal composition includes at least one amine-hydrogen fluoride salt species, additional hydrofluoric acid, material residue, water, optionally at least one organic solvent, optionally at least one chelating agent, and optionally at least one additional acid species. Importantly, even with residue material contained therein, the removal composition of the first aspect remains viable for continued/recycled use. It should be appreciated that the residue material may be dissolved in and/or suspended in the removal composition.

The embodiments of the first aspect may be formulated in the following Formulations A-BB, wherein all percentages are by weight, based on the total weight of the formulation:
Formulation A: Tetrafluoroboric acid 4.7 wt%; Triethanolamine:HF 11.7 wt%; HF 1.7 wt%; Ethylene glycol 39.6 wt%; Sulfolane 10.0 wt%; Butyl carbitol 15.0 wt%; Water 17.3 wt%
Formulation B: Tetrafluoroboric acid 4.7 wt%; Pyridine:HF 16.0 wt%; HF 1.7 wt%; Ethylene glycol 39.6 wt%; Sulfolane 10.0 wt%; Butyl carbitol 15.0 wt%; Water 13.0 wt%
Formulation C: Tetrafluoroboric acid 5.9 wt%; Pyridine:HF 8.0 wt%; HF 1.7 wt%; Ethylene glycol 39.6 wt%; Sulfolane 10.0 wt%; Butyl carbitol 19.0 wt%; Water 15.8 wt%
Formulation D: Acetic acid 17.0 wt%; Pyridine:HF 27.0 wt%: HF 1.2 wt%; Ethylene glycol 27.6 wt%; Sulfolane 10.0 wt%; DMSO 16.0 wt%; Water 1.2 wt%
Formulation E: Pyridine:HF 32.0 wt%; HF 1.3 wt%; Ethylene glycol 32.4 wt%; Sulfolane 13.0 wt%; DMSO 20.0 wt°,%; Water 1.3 wt%
Formulation F: Pyridine:HF 32.0 wt%; Propylene glycol 35.0 wt%; Sulfolane 13.0 wt%; DMSO 20.0 wt%
Formulation G: Pyridine:HF 31.1 wt%; HF 1.4 wt%; Propylene glycol 34.1 wt%; Sulfolane 12.6 wt%; DMSO 19.4 wt%; Water 1.4 wt%
Formulation H: Pyridine:HF 32.0 wt%; HF 1.7 wt%; Ethylene glycol 39.6 wt%; Sulfolane 10.0 wt%; DMSO 15.0 wt%; Water 1.7 wt%
Formulation I: Acetic acid 13.0 wt%; Isoxazole 7.0 wt%; HF 16.2 wt%; Ethylene glycol 22.1 wt%; Sulfolane 10.0 wt%; DMSO 15.0 wt%; Water 16.7 wt%
Formulation J: Acetic acid 13.0 wt%; 1,2,4-Triazole 7.0 wt%; HF 16.2 wt%; Ethylene glycol 22.1 wt%; Sulfolane 10.0 wt%; DMSO 15.0 wt%; Water 16.7 wt%
Formulation K: Acetic acid 13.0 wt%; Isoxazole 7.0 wt%; HF 16.3 wt%; Ethylene glycol 24.0 wt%; Sulfolane 15.0 wt%; Water 24.7 wt%
Formulation L: Acetic acid 13.0 wt%; Isoxazole 7.0 wt%; HF 16.3 wt%; Ethylene glycol 24.0 wt%; Sulfolane 10.0 wt%; NMP 13.0 wt%; Water 16.7 wt%
Formulation M: Acetic acid 13.0 wt%; Isoxazole 7.0 wt%; HF 16.3 wt%; Ethylene glycol 24.0 wt%; Sulfolane 10.0 wt%; Methyl carbitol 13.0 wt%; Water 16.7 wt%
Formulation N: Acetic acid 13.0 wt%; Isoxazole 7.0 wt%; HF 16.3 wt%; Ethylene glycol 24.0 wt%; Sulfolane 10.0 wt%; Dipropylene glycol methyl ether 13.0 wt%; Water 16.7 wt%
Formulation O: Acetic acid 15.0 wt%; Isoxazole 9.0 wt%; HF 17.2 wt%; Ethylene glycol 25.9 wt%; Sulfolane 15.0 wt%; Water 17.9 wt%
Formulation P: Isoxazole 10.3 wt%; HF 20.4 wt%; Ethylene glycol 30.7 wt%; Sulfolane 17.2 wt%; Water 21.4 wt%
Formulation Q: acetic acid 21.1 wt%; Isoxazole 12.0 wt%; HF 23.0 wt%; Sulfolane 20.0 wt%; Water 23.9 wt%
Formulation R: acetic acid 18.0 wt%; Isoxazole 10.2 wt%; HF 20.2 wt%; Sulfolane 30.4 wt%; Water 21.2 wt%
Formulation S: acetic acid 26.4 wt%; Isoxazole 15.0 wt%; HF 28.7 wt%; Water 29.9 wt%
Formulation T: Isoxazole 15.2 wt%; HF 29.1 wt%; Sulfolane 25.4 wt%; Water 30.3 wt%
Formulation U: Isoxazole 20.4 wt%; HF 39.0 wt%; Water 40.6 wt%
Formulation V: 2-ethylpyridine 20.4 wt%; HF 39.0 wt%; Water 40.6 wt%
Formulation W: 2-Methoxypyridine 20.4 wt%; HF 39.0 wt%; Water 40.6 wt%
Formulation X: Piperidine 20.4 wt%; HF 39.0 wt%; Water 40.6 wt%
Formulation Y: NMMO 8.0 wt%; HF 17.6 wt%; Sulfolane 15.0 wt%; Butyl carbitol 33.0 wt%; Water 26.4 wt%
Formulation Z: 2-Methoxypyridine 7.0 wt%; HF 15.7 wt%; Sulfolane 61.0 wt%; Water 16.3 wt%
Formulation AA: NMMO 7.0 wt%; HF 15.7 wt%; Water 77.3 wt%
Formulation BB: NMMO 7.0 wt%; HF 15.7 wt%; Sulfolane 10.0 wt%; Water 67.3 wt%

Preferably, the range of weight percent ratios of the components are: about 0.1:1 to about 10:1 etchant(s) (e.g., HF and/or amine:HF) relative to amine(s), preferably about 1:1 to about 5:1, and most preferably about 2:1 to about 3:1.

In a particularly preferred embodiment, the composition comprises, consists of or consists essentially of NMMO, HF and water.

In a second aspect, removal compositions are disclosed that are useful in removing at least one material selected from the group consisting of post-etch residue, low-k dielectric, high-k dielectric, barrier layer material, ferroelectrics, nitrides, silicides, oxides, photoresist, polymer-containing material, ARC material, doped regions, miscellaneous materials, and combinations thereof from the surface of a microelectronic device structure. The removal compositions of the second aspect also usefully remove A1 and SiCN. Preferably, the compositions of the second aspect are substantially devoid of amine species. By reducing the amount of amine present, the overall cost of the removal composition decreases and many supply chain problems are minimized. In addition, amines are known to react exothermically with HF, which can potentially lead to manufacturing issues such as particle generation. As defined herein, "substantially devoid" corresponds to less than about 1 wt. %, more preferably less than 0.5 wt. %, and most preferably less than 0.1 wt. % of the composition, based on the total weight of said composition.

Accordingly, the second aspect may include at least one etchant source, e.g., a fluoride species such as hydrofluoric acid, and at least one organic solvent. More specifically, the compositions of the second aspect may comprise, consist of, or consist essentially of at least one etchant, e.g., HF, at least one organic solvent, optionally water, optionally at least one organic acid, and optionally at least one chelating agent, present in the following ranges, based on the total weight of the composition:

| component | % by weight |
|---|---|
| etchant(s) | about 0.01 % to about 50.0% |
| organic solvent(s) | about 20% to about 70.0% |
| optional organic acid(s) | 0 to about 80.0% |
| optional chelating agent(s) | 0 to about 10% |
| water | 0 to about 80% |

In general, the specific proportions and amounts of etchant source(s), organic solvent(s), optional water, optional organic acid(s), and optional chelating agent(s), in relation to each other, may be suitably varied to provide the desired removal action of the composition for the materials selected from the group consisting of post-etch residue, low-k dielectric, high-k dielectric, barrier layer material, ferroelectrics, nitrides, silicides, oxides, photoresist, polymer-containing material, ARC material, doped regions, miscellaneous materials, and combinations thereof, and/or processing equipment, as readily determinable within the skill of the art without undue effort.

Preferably, the second aspect includes at least 10 wt % HF, based on the total weight of the composition. When copper stack material is not to be removed, the removal composition of the second aspect is devoid of oxidizer and/or carbonate-containing species. Further, the amount of water present in the removal composition of the second aspect is preferably in a range from 10 wt % to 80 wt. %, more preferably 10 wt% to about 75 wt%, based on the total weight of the composition.

Compositions of the second aspect have a pH value in a range from about 1 to about 7, more preferably about 2.5 to about 4.5, most preferably about 2.8 to about 3.5, when diluted 20:1 with deionized water.

The preferred etchant(s), organic solvent(s), optional chelating agent(s), and optional organic acid(s) species were previously introduced hereinabove. Preferably, the water is deionized.

Such compositions may optionally include additional components, including active as well as inactive ingredients, e.g., surfactants, rheology agents, stabilizers, passivators, chelating agents, dispersants, pH stabilizing agents, oxidants, etc. For example, about 0.01 wt. % to about 10 wt. % surfactant may be added to the removal composition of the second aspect of the invention, as described in the first aspect herein. When surfactants are included in the compositions of the invention, preferably defoaming agents are added in a range from 0 to 5 wt. %, based on the total weight of the composition. The defoaming agents were described in the first aspect herein.

Preferably, an embodiment of the second aspect may be present in concentrated form and includes the following components present in the following ranges, based on the total weight of the composition:

| component | % by weight | preferred % by weight |
|---|---|---|
| hydrofluoric acid | about 5% to about 70% | about 15% to about 30% |
| organic solvent(s) | about 10% to about 80% | about 50% to about 76% |
| water | about 0.01% to 80% | about 0.01% to about 80% |

and the pH of a 20:1 dilution of the removal composition of the second aspect in deionized water is in a range from about 2.5 to about 4.5. Optionally, about 0.01 wt. % to about 10 wt. % surfactant may be added.

In one embodiment of the second aspect, the removal composition comprises, consists of, or consists essentially of NF, at least two organic solvents and water.

In one embodiment of the second aspect, the removal composition is used to reclaim the microelectronic device structure. In other words, one removable layer or more than one removable layer may be removed from the microelectronic device structure.

In another embodiment of the second aspect, the removal composition may be used to rework the microelectronic device structure, whereby the polymer-containing buildup on the backside and/or bevel edge of the structure is removed. The processes of removing the polymer-containing buildup from the backside and/or bevel edge of the structure were described in the first aspect herein.

In still another embodiment of the second aspect, the removal composition may be adapted to remove SiCOH films by adding at least one oxidizing agent to the removal composition, preferably in a range from about 3 wt% to about 20 wt%, based on the total weight of the composition. Oxidizing agents contemplated herein include, but are not limited to, hydrogen peroxide (H₂O₂), FeCI₃ (both hydrated and unhydrated), oxone (2KHSO₅·KHSO₄·K₂SO₄), ammonium polyatomic salts (e.g., ammonium peroxomonosulfate, ammonium chlorite (NH₄CIO₂), ammonium chlorate (NH₄CIO₃), ammonium iodate (NH₄IO₃), ammonium perborate (NH₄BO₃), ammonium perchlorate (NH₄CIO₄), ammonium periodate (NH₄IO₃), ammonium persulfate ((NH₄)₂S₂O₈), ammonium hypochlorite (NH₄CIO)), sodium polyatomic salts (e.g., sodium persulfate (Na₂S₂O₈), sodium hypochlorite (NaCIO)), potassium polyatomic salts (e.g., potassium iodate (KIO₃), potassium permanganate (KMnO₄), potassium persulfate, nitric acid (HNO₃), potassium persulfate (K₂S₂O₈), potassium hypochlorite (KCIO)), tetramethylammonium polyatomic salts (e.g., tetramethylammonium chlorite ((N(CH₃)₄)CIO₂), tetramethylammonium chlorate ((N(CH₃)₄)CIO₃), tetramethylammonium iodate ((N(CH₃)₄)IO₃), tetramethylammonium perborate ((N(CH₃)₄)BO₃), tetramethylammonium perchlorate ((N(CH₃)₄)CIO₄). tetramethylammonium periodate ((N(CH₃)₄)IO₄), tetramethylammonium persulfate ((N(CH₃)₄)S₂O₈)), tetrabutylammonium polyatomic salts (e.g., tetrabutylammonium peroxomonosulfate), peroxomonosulfuric acid, ferric nitrate (Fe(NO₃)₃), urea hydrogen peroxide ((CO(NH₂)₂)H₂O₂), peracetic acid (CH₃(CO)OOH), and combinations thereof. The oxidizing agent may be introduced to the composition at the manufacturer, prior to introduction of the composition to the device wafer, or alternatively at the device wafer, i.e., *in situ.*

Further, the removal composition of the second aspect may further include material residue selected from the group consisting of post-etch residue, low-k dielectric, high-k dielectric, barrier layer material, ferroelectrics, nitrides, silicides, oxides, photoresist, polymer-containing material, ARC material, doped regions, miscellaneous materials, and combinations thereof. Preferably, the materials are dissolved in and/or suspended in the removal composition and the removal composition remains viable for its intended use.

The removal compositions of the second aspect may be formulated in the following Formulations CC-HH, wherein all percentages are by weight, based on the total weight of the formulation:
Formulation CC: HF 20.1 wt%; Butyl carbitol 57.5 wt%; Sulfolane 1.5 wt%; Water 20.9 wt%
Formulation DD: HF 37.4 wt%; Butyl carbitol 21.7 wt%; Sulfolane 2.2 wt%; Water 38.7 wt%
Formulation EE: HF 20.1 wt%; Butyl carbitol 21.7 wt%; Sulfolane 2.2 wt%; Water 56.0 wt%
Formulation FF: 10.04% HF, 10.8% butyl carbitol, 2.2% sulfolane and 76.96% water
Formulation GG: HF 20.1 wt%; Butyl carbitol 10.8 wt%; Sulfolane 2.2 wt%; Water 66.9 wt%
Formulation HH: HF 20.1 wt%; Butanol 10.8 wt%; Sulfolane 2.2 wt%; Water 66.9 wt%

Most preferably, the second aspect relates to a removal composition comprising, consisting of, or consisting essentially of hydrogen fluoride, diethylene glycol monobutyl ether, sulfolane and water. The range of weight percent ratios of the components are: about 0.1:1 to about 10:1 solvent(s) relative to etchant(s) (e.g., HF), preferably about 0.5:1 to about 5:1, and most preferably about 1:1 to about 3:1.

In a particularly preferred embodiment of the second aspect, the removal composition may comprise, consist of, or consist essentially of water, sulfolane, diethylene glycol butyl ether, and hydrogen fluoride, wherein the amount of water is in a range from 10 wt. % to about 75 wt. %, based on the total weight of the composition. Preferably, the composition is substantially devoid of amine.

In a third aspect of the invention, the removal compositions include an etchant source, e.g., a fluoride source such as hydrofluoric acid, at least one organic solvent, at least one oxidizing agent, and optionally water. Preferably, the composition is substantially devoid of amine. This compositional embodiment is particularly useful for the removal of low-k dielectric material, etch stop layers, metals, nitrides, silicides, oxides, photoresist, polymer-containing material, ARC material, and/or the metal film stacks without damaging the underlying device substrate and without the re-deposition or precipitation of copper salts or other contaminants on the surface of said substrate.

In the broad practice of the third aspect, the removal composition may comprise, consist of, or consist essentially of at least one etchant source, e.g., hydrofluoric acid, at least one organic solvent, at least one oxidizing agent, and optionally water. In general, the specific proportions and amounts of etchant source(s), organic solvent(s), oxidizing agent(s), and optional water, in relation to each other, may be suitably varied to provide the desired removal action of the composition for the materials selected from the group consisting of low-k dielectric material, etch stop layers, metal stack materials, metals, nitrides, silicides, oxides, photoresist, polymer-containing material, ARC material, and combinations thereof, and/or processing equipment, as readily determinable within the skill of the art without undue effort.

The preferred etchant(s), organic solvent(s), and oxidizing agent(s) were previously introduced hereinabove. Preferably, the water is deionized.

Preferably, the removal compositions of the third aspect may be present in concentrated form and may comprise, consist of or consist essentially of the following components present in the following ranges, based on the total weight of the composition:

| component | % by weight | preferred/% by weight |
|---|---|---|
| hydrofluoric acid | about 10% to about 60% | about 15% to about 50% |
| organic solvent(s) | about 10% to about 80% | about 20% to about 75% |
| water | about 0.01 % to about 80% | about 0.01 % to about 80% |
| oxidizing agent | about 0. 1% to about 25% | about 1% to about 20% |

and the pH of a 20:1 dilution of the removal composition of the third aspect in deionized water is in a range from about 2.5 to about 4.5.

Such compositions may optionally include additional components, including active as well as inactive ingredients, e.g., surfactants, rheology agents, stabilizers, passivators, chelating agents, dispersants, pH stabilizing agents, etc. For example, about 0.01 wt. % to about 10 wt. % surfactant may be added to the removal composition of the third aspect, as described in the first aspect herein. When surfactants are included in the compositions of the invention, preferably defoaming agents are added in a range from 0 to 5 wt. %, based on the total weight of the composition. The defoaming agents were described in the first aspect herein.

Further, the removal composition of the third aspect may further include material residue selected from the group consisting of low-k dielectric material, etch stop layers, metal stack materials, metals, silicides, nitrides, oxides, photoresist and combinations thereof. Preferably, the material residue dissolves in and/or is suspended in the removal composition and the removal composition remains viable for continued use.

The removal compositions of the third aspect may be formulated in the following Formulations II-KK, wherein all percentages are by weight, based on the total weight of the formulation:
Formulation II: HF 18.3 wt%; Butyl carbitol 52.3 wt%; Sulfolane 1.3 wt%; Water 19 wt%; H₂O₂ 9.1 wt%
Formulation JJ: HF 20.1 wt%; Butyl carbitol 21.7 wt%; Sulfolane 2.2 wt%; H₂O₂ I wt%; Water 55.0 wt%
Formulation KK: HF 20.1 wt%; Butyl carbitol 21.7 wt%; Sulfolane 2.2 wt%; HNO₃ 0.97 wt%; Water 55.3 wt%

In one embodiment of the third aspect, the removal composition is used to reclaim the microelectronic device structure. In other words, one removable layer or more than one removable layer may be removed from the microelectronic device structure.

In another embodiment of the third aspect, the removal composition may be used to rework the microelectronic device structure, whereby the polymer-containing buildup on the backside and/or bevel edge of the structure is removed. The processes of removing the polymer-containing buildup from the backside and/or bevel edge of the structure were described in the first aspect herein.

In a fourth aspect , the compositions include at least one etchant source, e.g., a fluoride source such as hydrofluoric acid, at least one organic solvent, at least one oxidizing agent, at least one copper chelating agent, and optionally water. Preferably, the composition of the fourth aspect is substantially devoid of amine. This compositional embodiment is particularly useful for the removal of post-etch residue, low-k dielectric material, high-k dielectric material, metals and metal film stacks, nitrides, silicides, oxides, barrier layer material, ferroelectrics, photoresist, ARC materials, polymer-containing buildup, doped regions and/or the miscellaneous materials without damaging the underlying device substrate and without the re-deposition or precipitation of copper salts or other contaminants on the surface of said substrate. The removal composition of the fourth aspect also usefully removes SiCN.

In the broad practice of the fourth aspect, the removal composition may comprise, consist of, or consist essentially of at least one etchant, e.g., HF, at least one organic solvent, at least one oxidizing agent, at least one chelating agent, and optionally water. In general, the specific proportions and amounts of etchant source(s), organic solvent(s), oxidizing agent(s), chelating agent(s), and optional water, in relation to each other, may be suitably varied to provide the desired removal action of the composition for the materials selected from the group consisting of post-etch residue, low-k dielectric material, high-k dielectric material, metals and metal film stacks, nitrides, silicides, oxides, barrier layer material, ferroelectrics, photoresist, ARC materials, polymer-containing buildup, doped regions and/or the miscellaneous materials, and/or processing equipment, as readily determinable within the skill of the art without undue effort.

The preferred organic solvent(s), chelating agent(s), and oxidizing agent(s) were previously introduced hereinabove. Preferably, the water is deionized.

Preferably, an embodiment of the fourth aspect are present in concentrated form and may comprise, consist of, consist essentially of, the following components present in the following ranges, based on the total weight of the composition:

| component | % by weight | preferred/% by weight |
|---|---|---|
| hydrofluoric acid | about 5% to about 55% | about 10% to about 45% |
| organic solvent(s) | about 5% to about 70% | about 10% to about 60% |
| water | 0 to about 90% | about 0.01 % to 90% |
| oxidizing agent | about 0.1 % to about 15% | about I % to about 10% |
| chelating agent | about 0.01 % to about 5% | about 0.1 % to about 2% |

and the pH of a 20:1 dilution of the removal composition of the fourth aspect in deionized water is in a range from about 2.5 to about 4.5.

Such compositions may optionally include additional components, including active as well as inactive ingredients, e.g., surfactants, rheology agents, stabilizers, passivators, dispersants, pH stabilizing agents, etc. For example, about 0.01 wt. % to about 10 wt. % surfactant may be added to the removal composition of the fourth aspect, as described in the first aspect herein. When surfactants are included in the compositions of the invention, preferably defoaming agents are added in a range from 0 to 5 wt. %, based on the total weight of the composition. The defoaming agents were described in the first aspect herein.

The removal composition of the fourth aspect may further include material residue selected from the group consisting of post-etch residue, low-k dielectric material, high-k dielectric material, metals and metal film stacks, nitrides, silicides, oxides, barrier layer material, ferroelectrics, photoresist, ARC materials, polymer-containing buildup, doped regions, miscellaneous materials, and combinations thereof. Preferably, the material residue dissolves in and/or is suspended in the removal composition and the removal composition remains viable for continued use.

The fourth aspect may be formulated in the following Formulations LL-QQ, wherein all percentages are by weight, based on the total weight of the formulation:
Formulation LL: HF 20.1 wt%; Butyl carbitol 21.7 wt%; Sulfolane 2.2 wt%; H₂O₂ 1 wt%; CDTA 0.15 wt%; Water 54.85 wt%
Formulation MM: HF 20.1 wt%; Butyl carbitol 21.7 wt%; Sulfolane 2.2 wt%; H₂O₂ 1 wt%; EDTA 0.15 wt%; Water 54.85 wt%
Formulation NN: HF 20.1 wt%; Butyl carbitol 21.7 wt%; Sulfolane 2.2 wt% H₂O₂ 1 wt%; MEA 0.15 wt%; Water 54.85 wt%
Formulation OO: HF 10.04 wt%; Butyl carbitol 10. 8 wt%; Sulfolane 2.2 wt%; H₂O₂ I wt%; CDTA 0.15 wt%; Water 75.81 wt%
Formulation PP: HF 10.04 wt%; Butyl carbitol 10.8 wt%; Sulfolane 2.2 wt%; H₂O₂ I wt%; acac 2 wt%; Water 73.96 wt%
Formulation QQ: HF 10.04 wt%; Butyl carbitol 10.8 wt%; Sulfolane 2.2 wt%; H₂O₂ 5 wt%; CDTA 0.15 wt%; Water 71.81 wt%
Formulation RR: HF 20.1 wt%; Butyl carbitol 21.7 wt%; Sulfolane 2.2 wt%; H₂O₂ 5 wt%; CDTA 0.15 wt%; Water 50.85 wt%

Preferably, the range of weight percent ratios of the components are: about 0.1:1 to about 10:1 etchant(s) (e.g., HF) relative to oxidant(s), preferably about 0.5:1 to about 5:1, and most preferably about 2:1 to about 5:1; about 0.1:1 to about 10:1 solvent(s) relative to oxidant(s), preferably about 1:1 to about 6:1, and most preferably about 3:1 to about 6:1; about 0.001:1 to about 0.1 chelating agent(s) relative to oxidant(s), preferably about 0.01:1 to about 0.05:1.

Importantly, the chelating agent and/or the oxidizing agent may be introduced to the composition of the fourth aspect at the manufacturer, prior to introduction of the composition to the device wafer, or alternatively at the device wafer, i.e., *in situ.* It is further contemplated that in addition to chelating agent(s) and/or oxidizing agent(s), other components may be added to the composition to dilute, maintain and/or increase the concentration of other components in the composition.

It is known in the art that HF in the presence of metallic contaminants, including copper, causes pitting of microelectronic device substrates including silicon. To substantially eliminate this detrimental pitting effect, chloride sources such as, but not limited to, hydrochloric acid, alkali metal chlorides (e.g., NaCl, KCo, RbCl, CsCl, etc.), alkaline earth metal chlorides (e.g., MgCl₂, CaCl₂, SrCl₂, BaCl₂, etc.) and ammonium chloride, may be added to the removal composition of the fourth aspect to minimize pitting of the microelectronic device substrate during the reclamation process. For example, about 0.01 wt. % to about 5 wt. % concentrated HCl, preferably about 0.1 wt.% to about 4 wt.% concentrated HCl, and more preferably about 0.5 wt.% to about 3 wt.% concentrated HCl, based on the total weight of the composition, may be added to the removal composition of the fourth aspect. Put another way, the range of weight percent ratios of the components are: about 0.1:1 to about 10:1 oxidant(s) relative to concentrated HCl, preferably about 1:1 to about 7:1, and most preferably about 1:1 to about 5:1; about 0.1:1 to about 25:1 etchant(s) (e.g., HF) relative to concentrated HCl, preferably about 1:1 to about 20:1, and most preferably about 5:1 to about 15:1; about 0.001:1 to about 1:1 chelating agent(s) relative to concentrated HCl, preferably about 0.01:1 to about 0.3:1; and about 1:1 to about 30:1 solvent(s) relative to concentrated HCl, preferably about 5:1 to about 25:1, and most preferably about 5:1 to about 20:1. One skilled in the art will be able to calculate new weight percents when an HCl solution that is not concentrated or a chloride salt is used instead.

In one embodiment of the fourth aspect, the removal composition is used to reclaim the microelectronic device structure. In other words, one removable layer or more than one removable layer may be removed from the microelectronic device structure.

In another embodiment of the fourth aspect, the removal composition may be used to rework the microelectronic device structure, whereby the polymer-containing buildup on the backside and/or bevel edge of the structure is removed. The processes of removing the polymer-containing buildup from the backside and/or bevel edge of the structure were described in the first aspect herein.

The fifth aspect relates to removal compositions compliant with national and international environmental standards, so-called "green" removal compositions. Diethylene glycol butyl ether and other ethylene-containing solvents are HAP chemicals and can be detrimental to the environment. For example, diethylene glycol butyl ether has a very high chemical oxygen demand (COD) level, which is the mass of oxygen consumed per liter of solution. Because of its high COD level, diethylene glycol butyl ether has been either banned or limited to very low levels depending on the country.

A "green" removal composition according to the fifth aspect may include an etchant source, e.g., a fluoride source such as hydrofluoric acid, at least one surfactant, optionally water, optionally at least one organic solvent, optionally at least one organic acid, optionally at least one oxidizing agent, optionally at least one chloride source, and optionally at least one chelating agent, present in the following ranges, based on the total weight of the composition:

| component | % by weight |
|---|---|
| etchant(s) | about 0.01 % to about 50.0% |
| surfactant(s) | about 0.01 % to about 5.0% |
| optional organic solvent(s) | 0 to about 20.0% |
| optional organic acid(s) | 0 to about 80.0% |
| optional chelating agent(s) | 0 to about 10% |
| optional oxidizing agent(s) | 0 to about 10% |
| optional chloride source(s) | 0 to about 5% |
| water | 0 to about 99% |

and the pH of a 20:1 dilution of the removal composition of the fourth aspect in deionized water is in a range from about 2.5 to about 4.5.

The green removal composition may comprise, consist of, or consist essentially of at least one etchant, at least one surfactant, optionally water, optionally at least one organic solvent, optionally at least one organic acid, optionally at least one oxidizing agent, optionally at least one chloride source, and optionally at least one chelating agent. In general, the specific proportions and amounts of etchant source(s), surfactant(s), optional water, optional organic solvent(s), optional organic acid(s), optional oxidizing agent(s), optionally chloride source(s), and optional chelating agent(s), in relation to each other, may be suitably varied to provide the desired removal action of the composition for the materials selected from the group consisting of post-etch residue, low-k dielectric material, high-k dielectric material, barrier layer materials, ferroelectrics, nitrides, silicides, oxides, polymer-containing buildup, ARC materials, doped regions, miscellaneous materials, and combinations thereof, and/or processing equipment, as readily determinable within the skill of the art without undue effort. In an preferred embodiment, the green removal composition is substantially devoid of amine.

The preferred etchant(s), surfactant(s), optional organic solvent(s), optional chelating agent(s), optional oxidizing agent(s), optional chloride source(s), and optional organic acid(s) species were previously introduced hereinabove. Preferably, the water is deionized and preferably, the surfactant includes a species selected from the group consisting of dodecylbenzene sulfonic acid sodium salt (DDBSA), DowFax, NIAPROOF® 08, and combinations thereof. Given the nature of the green removal composition, preferably the composition is substantially devoid of organic solvents including ethylene groups, e.g., ethylene, diethylene, triethylene, etc., and other HAP organic solvents. For example, if an organic solvent is present, preferably it includes a propylene and/or propylene glycol ether.

Such compositions may optionally include additional components, including active as well as inactive ingredients, e.g., rheology agents, stabilizers, passivators, dispersants, pH stabilizing agents, etc.

In a preferred embodiment, the green removal composition comprises, consists of, or consists essentially of at least one etchant, at least one surfactant, water, and at least one organic solvent. In another preferred embodiment, the green removal composition comprises, consists of, or consists essentially of at least one etchant, at least one surfactant, water, at least one organic solvent, at least one oxidizing agent, at least one chloride source, and at least one chelating agent. In yet another preferred embodiment, the green removal composition comprises, consists of, or consists essentially of at least one etchant, at least one surfactant, water, at least one oxidizing agent, at least one chloride source, and at least one chelating agent.

The green removal composition may further include material residue selected from the group consisting of post-etch residue, low-k dielectric material, high-k dielectric material, barrier layer materials, ferroelectrics, nitrides, silicides, oxides, polymer-containing buildup, ARC materials, doped regions, miscellaneous materials, and combinations thereof. Preferably, the materials dissolve in and/or are suspended in the green removal composition and the removal composition remains viable for its intended use.

The green removal compositions may be formulated in the following Formulations G1-G5, wherein all percentages are by weight, based on the total weight of the formulation:
Formulation G1: HF 20.1 wt%; Sulfolane 2 wt%; DowFax 3B2 0.5 wt.%; Water 77.4 wt%
Formulation G2: HF 20.1 wt%; Sulfolane 2 wt%; DowFax 3B2 0.1 wt.%; Water 77.8 wt%
Formulation G3: HF 20.1 wt%; Sulfolane 2 wt%; DDBSA 0.5 wt.%; Water 77.4 wt%
Formulation G4: HF 20. wt%; Sulfolane 2 wt%; DowFax 3B2 0.1 wt.%; Water 77.8 wt%
Formulation G5: HF 20.1 wt%; Sulfolane 2.2 wt%; DowFax 3B2 0.5 wt.%; H₂O₂ 5 wt.%; HEDP 5 wt.%; Water 67.2 wt%
Formulation G6: HF 20.1 wt%; HCl (conc) 1 wt.%; Sulfolane 2.2 wt%; DowFax 3B2 0.5 wt.%; H₂O₂ 5 wt.%; HEDP 5 wt.%; Water 66.2 wt%
Formulation G7: HF 20.1 wt%; Sulfolane 1.5 wt%; DDBSA 0.5 wt.%; Water 77.9 wt%
Formulation G8: 20.1 wt% HF; 1.5 wt% sulfolane; 0.5 wt% Niaproof 08; 77.9 wt% water
Formulation G9: HF (49%) 41 wt%; HCl (conc) 1 wt.%; Sulfolane 2.2 wt%; Niaproof 08 0.5 wt.%; H₂O₂(50%) 10 wt.%; HEDP (60%) 8.3 wt.%; Water 37 wt%
Formulation G10: HF (49%) 20 wt%; HCl (conc) 10 wt.%; Niaproof 08 3 wt.%; H₂O₂(30%) 10 wt.%; HEDP (60%) 10 wt.%; Water 47 wt%

In one embodiment, the green removal compositions are formulated in the following concentrated embodiments, wherein all percentages are by weight, based on the total weight of the formulation:

| component of | % by weight | preferably (% by weight) | most preferably (% by weight) |
|---|---|---|---|
| HF | about 0.01% to about 90% | about 5% to about 90% | about 10% to about 50% |
| surfactant(s) | about 0.01% to about 15% | about 0.05% to about 5% | about 0.1% to about 3% |
| organic solvent(s) (non-ethylene glycol ethers) | 0 to about 25% | about 0.01% to about 10% | about 1% to about 10% |
| water | about 0.01% to 99% | about 0.01% to 99% | about 0.01% to 99% |

More preferably, this embodiment comprises, consists of, or consists essentially of hydrogen fluoride, a sulfone, at least one sodium ethylhexyl sulfate surfactant, and water. Most preferably, this embodiment comprises, consists of, or consists essentially of HF, tetramethylene sulfone, a sodium ethylhexyl sulfate surfactant, and water. The range of weight percent ratios of the components are: about 0.01:1 to about 1:1 organic solvent(s) relative to etchant(s), preferably about 0.05:1 to about 0.25:1, and most preferably about 0.05:1 to about 0.2:1; and about 1:1 to about 40:1 organic solvent(s) relative to surfactant(s), preferably about 2:1 to about 30:1, and most preferably about 3:1 to about 25:1.

Alternatively, the green removal compositions are formulated in the following concentrated embodiments, wherein all percentages are by weight, based on the total weight of the formulation:

| component of | % by weight | preferably (% by weight) | most preferably (% by weight) |
|---|---|---|---|
| HF | about 0.01% to about 90% | about 5% to about 75% | about 10% to about 40% |
| surfactant(s) | about 0.01% to about 15% | about 0.05% to about 5% | about 0.1 % to about 2% |
| organic solvent(s) (non-ethylene glycol ethers) | 0 to about 25% | about 0.01% to about 10% | about 1% to about 10% |
| oxidizing agent(s) | 0 to about 25% | about 0.1% to about 20% | about 1% to about 10% |
| chelating agent(s) | 0 to about 25% | about 0.1% to about 20% | about 1% to about 10% |
| chloride source(s) | 0 to about 25% | about 0.1% to about 10% | about 0.1 % to about 10% |
| water | about 0.01 % to 99% | about 5% to 90% | about 10% to 99% |

Most preferably, this embodiment comprises, consists of, or consists essentially of HF, HCl, sulfolane, H₂O₂, HEDP, at least one surfactant and water. The range of weight percent ratios of the components for this embodiment are: about 0.1:1 to about 15:1 organic solvent(s) relative to surfactant(s), preferably about 1:1 to about 10:1, and most preferably about 2:1 to about 7:1; about 10:1 to about 60:1 etchant(s) relative to surfactant(s), preferably about 15:1 to about 55:1, and most preferably about 25:1 to about 50:1; about 0.1:1 to about 25:1 oxidant(s) relative to surfactant(s), preferably about 1:1 to about 20:1, and most preferably about 5:1 to about 15:1; and about 0.1: to about 25:1 chelating agent(s) relative to surfactant(s), preferably about 1:1 to about 20:1, and most preferably about 5:1 to about 15:1.

In another alternative, the green removal compositions are formulated in the following concentrated embodiments, wherein all percentages are by weight, based on the total weight of the formulation:

| component of | % by weight | preferably (% by weight) | most preferably (% by weight) |
|---|---|---|---|
| HF | about 0.01% to about 90% | about 1% to about 65% | about 5% to about 40% |
| surfactant(s) | about 0.01% to about 15% | about 0.05% to about 5% | about 0.1% to about 4% |
| oxidizing agent(s) | 0 to about 25% | about 0.1% to about 20% | about 1% to about 10% |
| chelating agent(s) | 0 to about 25% | about 0.1% to about 20% | about 1% to about 10% |
| chloride source(s) | 0 to about 25% | about 0.1% to about 10% | about 0.1% to about 10% |
| water | about 0.01% to 99% | about 5% to 90% | about 10% to 99% |

Most preferably, this embodiment comprises, consists of, or consists essentially of HF, HCl, H₂O₂, HEDP, at least one surfactant and water. The range of weight percent ratios of the components for this embodiment are: about 0.1:1 to about 20:1 etchant(s) relative to surfactant(s), preferably about 0.5:1 to about 10:1, and most preferably about 1:1 to about 6:1; about 0.01:1 to about 15:1 oxidant(s) relative to surfactant(s), preferably about 0.1:1 to about 5:1, and most preferably about 0.5:1 to about 2:1; and about 0.1:1 to about 20:1 chelating agent(s) relative to surfactant(s), preferably about 0.5:1 to about 10:1, and most preferably about 1:1 to about 5:1.

Similar to the fourth aspect, hydrochloric acid may be added to the removal composition of the fifth aspect to minimize pitting of the microelectronic device substrate during the reclamation process, as described at length hereinabove. For the fifth aspect, the range of weight percent ratios of the components are: about 0.1:1 to about 10:1 oxidant(s) relative to concentrated HCl, preferably about 1:1 to about 8:1, and most preferably about 1:1 to about 7:1; about 0.1:1 to about 25:1 etchant(s) (e.g., HF) relative to concentrated HCl, preferably about 1:1 to about 20:1, and most preferably about 5:1 to about 20:1; about 0.01:1 to about 2:1 surfactant(s) relative to concentrated HCl, preferably about 0.1:1 to about 1:1; about 0.1:1 to about 10:1 chelating agent(s) relative to concentrated HCl, preferably about 1:1 to about 8:1, and most preferably about 1:1 to about 7:1; about 0.1:1 to about 10:1 solvent(s) relative to concentrated HCl, preferably about 0.5:1 to about 5:1, and most preferably about 0.5:1 to about 4:1.

In one embodiment of the fifth aspect, the removal composition is used to reclaim the microelectronic device structure. In other words, one removable layer or more than one removable layer may be removed from the microelectronic device structure.

In another embodiment of the fifth aspect, the removal composition may be used to rework the microelectronic device structure, whereby the polymer-containing buildup on the backside and/or bevel edge of the structure is removed. The processes of removing the polymer-containing buildup from the backside and/or bevel edge of the structure are described in the first aspect herein.

The low-k dielectric materials removed using the removal compositions of the first through the fifth aspects of the invention include CORAL^{™}, BLACK DIAMOND^{™} (hereinafter BD), derivatives of CORAL, derivatives of BD, AURORA®, derivatives of AURORA®, SiCOH, etc. As used herein, "derivatives of CORAL" and "derivatives of BD" correspond to CORAL and BD materials, respectively, that were deposited using alternative, often proprietary, deposition processes. The utilization of a different processing technique will result in a CORAL and BD material that differs from CORAL^{™} and BLACK DIAMOND^{™}, respectively.

It is noted that the removal compositions of the first through fifth aspects should be substantially devoid of abrasive material typically used during CMP processing prior to contact of the removal compositions with the microelectronic device.

Importantly, the removal compositions of the first though fifth aspects are effective at concurrently removing at least one of polymer-containing buildup, metal stack materials, low-k dielectric layers, high-k dielectric layers, etch stop layers, nitrides, silicides, oxides, barrier layers, photoresist, post-etch residue, miscellaneous materials, doped regions (other than doped epitaxial Si) and/or other material from a surface of the microelectronic device. For example, the removal compositions may effectively remove low-k dielectric material from the front side of the microelectronic device while concurrently removing polymer and other residue from the backside and/or bevel edge of the microelectronic device, as readily determined by one skilled in the art. As such, as applied to microelectronic device manufacturing operations, the removal compositions of the invention are usefully employed to remove at least one material selected from the group consisting of low-k dielectric material, high-k dielectric material, etch stop layers, metal stack materials, nitrides, silicides, oxides, photoresist, barrier layers, polymer-containing buildup, ferroelectrics, miscellaneous materials, doped regions (other than doped epitaxial Si) and combinations thereof, from microelectronic device structures in a single reclamation or rework step for recycling and/or reuse of said structures. Importantly, the removal compositions of the first through fifth aspects satisfy the reclamation requirements, including, but not limited to: less than 25 particles at 0.25 µm, less than 50 particles at 0.12 µm, or less than 100 particles at 0.09 µm, a total thickness variation (TTV) of less than about 5 µm (without the need for a post-removal planarization process), a surface metal contamination of less than 1 × 10¹⁰ atoms cm⁻²; and/or the thickness of a reclaimed substrate (devoid of any other retained layers) is within 5 %, preferably within 2%, and most preferably within 1%, of the thickness of the original substrate; as well as the rework/clean requirements. Furthermore, because of the low TTV, the chemical mechanical polishing (CMP) step that is typical of current reclaiming practices, i.e., to planarize the substrate subsequent to the wet removal of the materials, may not be needed to planarize the front-side or backside of the wafer before reuse. Alternatively, the parameters of the CMP step may be altered such that the energy requirements are substantially reduced, e.g., the length of time of the polish is shortened, etc. Most preferably, the TTV is less than 3%, more preferably less than 1% and most preferably less than 0.5%, subsequent to the removal of the materials from the microelectronic device substrate.

In addition, the removal compositions of the first through fifth aspects satisfy the rework requirements, e.g., effectuate the substantial removal of photoresist, polymeric-containing buildup, and/or electroplated copper from the outermost edge and backside of the device substrate without substantial damage to the layer(s) to be retained. Importantly, unlike rework compositions in the prior art (e.g., physical polish of the edge, a dry plasma etch, combustion, etc.) the at least one material to be removed from the microelectronic device structure may be removed with a wet solution(s).

It should be appreciated that any of the removal compositions of the first through fifth aspects disclosed herein may be used during (CMP) processes, i.e., to planarize copper and remove barrier layer materials, to accelerate the removal of CDO and other low-k dielectric materials, as readily determinable by one skilled in the art. Importantly, when the application requires stopping on a copper layer, for example during CMP processing, and the removal composition (e.g., any of the first through fifth aspects) includes at least one chelating agent, the removal composition preferably further includes at least one copper passivator species. Contemplated copper passivator species include, but are not limited to, 1,2,4-triazole, benzotriazole (BTA), tolyltriazole, 5-phenyl-benzotriazole, 5-nitro-benzotriazole, 3-amino-5-mercapto-1,2,4-triazole, 1-amino-1,2,4-triazole, hydroxybenzotriazole, 2-(5-amino-pentyl)-benzotriazole, 1-amino-1,2,3-triazole, 1-amino-5-methyl-1,2,3-triazole, 3-amino-1,2,4-triazole, 3-mercapto-1,2,4-triazole, 3-isopropyl-1,2,4-triazole, 5-phenylthiol-benzotriazole, halo-benzotriazoles (halo = F, Cl, Br or I), naphthotriazole, 2-mercaptobenzoimidizole (MBI), 2-mercaptobenzothiazole, 4-methyl-2-phenylimidazole, 2-mercaptothiazoline, 5-aminotetrazole (ATA), 5-amino-1,3,4-thiadiazole-2-thiol, 2,4-diamino-6-methyl-1,3,5-triazine, thiazole, triazine, methyltetrazole, 1,3-dimethyl-2-imidazolidinone, 1,5-pentamethylenetetrazole, 1-phenyl-5-mercaptotetrazole, diaminomethyltriazine, mercaptobenzothiazole, imidazoline thione, mercaptobenzimidazole, 4-methyl-4H-1,2,4-triazole-3-thiol, 5-amino-1,3,4-thiadiazole-2-thiol, benzothiazole, tritolyl phosphate, indiazole, and combinations thereof. Di- and poly-carboxylic acids such as oxalic acid, malonic acid, succinic acid, nitrilotriacetic acid, iminodiacetic acid, and combinations thereof are also useful copper passivator species. It is also contemplated herein that the removal compositions may be diluted with a solvent such as water and used as a post-chemical mechanical polishing (CMP) composition to remove post-CMP residue including, but not limited to, particles from the polishing slurry, carbon-rich particles, polishing pad particles, brush deloading particles, equipment materials of construction particles, copper, copper oxides, and any other materials that are the by-products of the CMP process. When used in post-CMP applications, the concentrated removal compositions may be diluted in a range from about 1:1 to about 1000:1 solvent to concentrate, wherein the solvent can be water and/or organic solvent.

In yet another aspect, any of the removal compositions disclosed herein may be buffered to a pH in a range from about 5 to about 8, preferably about 5.5 to about 7, to minimize corrosion of the materials of construction in the fab, e.g., steel drainage systems and other tools, as readily determinable by one skilled in the art. Contemplated buffering species include, but are not limited to organic quaternary bases, alkali bases, alkaline earth metal bases, organic amines, alkoxides, amides, and combinations thereof. More specifically, the buffering species may include benzyltrimethylammonium hydroxide, benzyltriethylammonium hydroxide, benzyltributylammonium hydroxide, dimethyldiethylammonium hydroxide, tetramethyl ammonium hydroxide, tetraethyl ammonium hydroxide, tetrapropyl ammonium hydroxide, tetrabutyl ammonium hydroxide, ammonium hydroxide, potassium hydroxide, cesium hydroxide, rubidium hydroxide, alkyl phosphonium hydroxides, and derivatives thereof, Aniline, Benzimidazole, Benzylamine, I-Butanamine, *n*-Butylamine, Cyclohexanamine, Diisobutylamine, Diisopropylamine, Dimethylamine, Ethanamide, Ethanamine, Ethylamine, Ethylenediamine, 1-Hexanamine, 1,6-Hexanediamine, Pyrazine, Pyridazine, Urea, N-methylpyrrolidone, diglycolamine, pyridine, triethylamine, monoethanolamine, triethanolamine, aminoethylethanolamine, N-methylaminoethanol, aminoethoxyethanol, dimethylaminoethoxyethanol, diethanolamine, N-methyldiethanolamine, 2 methoxy pyridine, isoxazole, 1,2,4 triazole and derivatives and combinations thereof.

### Processes and Kits

The removal compositions are easily formulated by simple addition of the respective ingredients and mixing to homogeneous condition. Furthermore, the removal compositions may be readily formulated as single-package formulations or multi-part formulations that are mixed at the point of use. The individual parts of the multi-part formulation may be mixed at the tool or in a storage tank upstream of the tool. The concentrations of the respective ingredients may be widely varied in specific multiples of the removal composition, e.g., more dilute or more concentrated, in the broad practice of the invention, and it will be appreciated that the removal compositions of the invention can variously and alternatively comprise, consist or consist essentially of any combination of ingredients consistent with the disclosure herein. In one embodiment, the concentrates of the removal compositions is anhydrous and water may be added by the user at the fab.

Accordingly, another aspect relates to concentrated formulations of the compositions described in the first through fifth aspects with low amounts of water and/or solvent, or alternatively without water and/or solvent, wherein water and/or solvent may be added prior to use to form the removal compositions of the invention. The concentrated formulations may be diluted in a range from about 1:10 to 100:1 solvent to concentrate, wherein the solvent can be water and/or organic solvent. In one embodiment, the concentrates of the removal compositions is anhydrous and water may be added by the user at the fab.

Another aspect relates to a kit including, in one or more containers, one or more components adapted to form the removal compositions of the invention. The kit may include, in one or more containers, at least one amine, hydrofluoric acid, optionally at least one organic solvent, optionally at least one chelating agent, optionally at least one additional acid, and optionally water for combining as is or with diluent (e.g., water and/or organic solvent) at the fab. Alternatively, the kit may include at least one amine, hydrofluoric acid, at least one organic solvent, at least one additional acid, and optionally water, for combining as is or with diluent (e.g., water and/or organic solvent) at the fab. In still another embodiment, the kit may include at least one amine, hydrofluoric acid, at least one organic solvent, and optionally water, for combining as is or with diluent (e.g., water and/or organic solvent) at the fab. In yet another alternative, the kit may include, in one or more containers, at least one amine-hydrogen fluoride salt, additional hydrofluoric acid, at least one organic solvent, optionally water, and optionally at least one additional acid, for combining as is or with diluent (e.g., water and/or organic solvent) at the fab.

Alternatively, the kit may include, in one or more containers, hydrofluoric acid, at least one organic solvent, optionally at least one chelating agent, optionally at least one surfactant, optionally water, and optionally at least one organic acid, for combining as is or with diluent (e.g., water and/or organic solvent) at the fab. In another embodiment, the kit may include, in one or more containers, hydrofluoric acid, at least one organic solvent, at least one oxidizing agent, at least one chelating agent, and optionally water, for combining as is or with diluent (e.g., water, organic solvent and/or oxidizing agent) at the fab. In still another embodiment, the kit may include, in one or more containers, hydrofluoric acid, at least one surfactant, optionally water, optionally at least one organic solvent, optionally at least one organic acid, optionally at least one chloride source, and optionally at least one chelating agent for combining as is or with diluent (e.g., water, organic solvent and/or oxidizing agent) at the fab. It should be appreciated that the kit may include any of the components of the foregoing embodiments, in any combination, as readily determined by one skilled in the art.

The containers of the kit should be chemically rated to store and dispense the component(s) contained therein. For example, the containers of the kit may be NOWPak® containers (Advanced Technology Materials, Inc., Danbury, Conn., USA). The one or more containers which contain the components of the removal composition preferably include means for bringing the components in said one or more containers in fluid communication for blending and dispense. For example, referring to the NOWPak® containers, gas pressure may be applied to the outside of a liner in said one or more containers to cause at least a portion of the contents of the liner to be discharged and hence enable fluid communication for blending and dispense. Alternatively, gas pressure may be applied to the head space of a conventional pressurizable container or a pump may be used to enable fluid communication. In addition, the system preferably includes a dispensing port for dispensing the blended removal composition to a process tool.

Substantially chemically inert, impurity-free, flexible and resilient polymeric film materials, such as high density polyethylene, are preferably used to fabricate the liners for said one or more containers. Desirable liner materials are processed without requiring co-extrusion or barrier layers, and without any pigments, UV inhibitors, or processing agents that may adversely affect the purity requirements for components to be disposed in the liner. A listing of desirable liner materials include films comprising virgin (additive-free) polyethylene, virgin polytetrafluoroethylene (PTFE), polypropylene, polyurethane, polyvinylidene chloride, polyvinylchloride, polyacetal, polystyrene, polyacrylonitrile, polybutylene, and so on. Preferred thicknesses of such liner materials are in a range from about 5 mils (0.005 inch) to about 30 mils (0.030 inch), as for example a thickness of 20 mils (0.020 inch).

Regarding the containers for the kits of the invention, the disclosures of the following patents and patent applications are hereby incorporated herein by reference in their respective entireties: U.S. Patent No. 7,188,644 entitled "APPARATUS AND METHOD FOR MINIMIZING THE GENERATION OF PARTICLES IN ULTRAPURE LIQUIDS;" U.S. Patent No. 6,698,619 entitled "RETURNABLE AND REUSABLE, BAG-IN-DRUM FLUID STORAGE AND DISPENSING CONTAINER SYSTEM;" and U.S. Patent Application No. 60/916,966 entitled "SYSTEMS AND METHODS FOR MATERIAL BLENDING AND DISTRIBUTION" filed on May 9, 2007 in the name of John E.Q. Hughes.

In addition to a liquid solution, it is also contemplated herein that the removal compositions may be formulated as foams, fogs, dense fluids (i.e., supercritical or subcritical, wherein the solvent is CO₂, etc., in addition to or in lieu of water and/or organic solvent(s)).

Importantly and advantageously, the removal compositions dissolve or delaminate at least one material selected from the group consisting of post-etch residue, low-k dielectric material, high-k dielectric material, etch stop layers, nitrides, silicides, oxides, metal stack materials, ferroelectrics, barrier layers, photoresist, ARC material, polymer-containing buildup, doped regions, and combinations thereof from the microelectronic device substrate in a single step (i.e., all of the material(s) to be removed may be removed by contacting the rejected microelectronic device substrate with a single composition for a single immersion). Most preferably, the removable materials are dissolved or delaminated in a single step, with the provision that no mechanical polishing is necessary prior to recycling and/or reuse. As defined herein, "dissolution" covers the process whereby a solid solute (e.g., the material to be removed) enters a solvent to form a solution. "Dissolution" is also intended to include the etching, decomposition, chemical polishing and combinations thereof, of the material to be removed. Dissolution has the advantage of minimizing the generation of particulate matter that may subsequently settle on said substrate as well as substantially eliminating clogging of the removal equipment.

Advantageously, the remaining layers of the microelectronic device structure following the removal process are substantially smooth and undamaged, preferably without the need to planarize the front side and/or backside prior to additional manufacturing processes, i.e., deposition processes of new layers of materials, e.g., low-k dielectric, high-k dielectric, photoresist, metal stack layers, etch stop layers, etc. For example, if following reclamation, the remaining layers include just the microelectronic device substrate and epitaxial Si layer, the substrate is preferably ready for recycling/reuse without the need for an expensive and structurally compromising mechanical polish. It should be appreciated that a mechanical polish may be used when necessary.

In yet another aspect, methods of removal are disclosed wherein at least one material selected from the group consisting of low-k dielectric layers, high-k dielectric materials, etch stop layers, metal stack materials, nitrides, silicides, oxides, ferroelectrics, barrier layers, photoresist, ARC materials, post-etch residue, polymer-containing buildup, doped regions, and combinations thereof are removed from a microelectronic device having said layers thereon. For example, low-k dielectric materials may be removed while maintaining the integrity of the underlying substrate and etch stop layers (e.g., SiCN, SiCO, SiC, SiON, SiGe, SiGeB, SiGeC, AlAs, InGaP, InP, InGaAs), and metal stack materials. Alternatively, low-k dielectric layers and metal stack materials may be removed while maintaining the integrity of the underlying substrate and/or etch stop layers. In another alternative, low-k dielectric layers, etch stop layers and metal stack materials may be removed while maintaining the integrity of the underlying substrate.

In a further aspect, the removal compositions disclosed herein may be used to clean the microelectronic device structure, whereby the polymer-containing buildup on the backside and/or bevel edge of the structure is removed. In one embodiment, the process of removing the polymer-containing buildup from the backside and/or bevel edge of the structure includes the positioning of the structure in a single wafer tool that protects the front side of the wafer using an inert gas, e.g., nitrogen gas and/or a deionized water spray. Alternatively, the front side may be protected by depositing a thick layer of photoresist or other protective coating polymer on the front side. In other words, the front side of the structure, which includes the blanketed or patterned layers that are not to be damaged, is not to be exposed to the removal composition when cleaning the backside and/or bevel edge. In another embodiment, both the front side and the backside/bevel edge is exposed to the removal composition to simultaneously remove material from the front side (e.g., low-k dielectric material) and the backside/bevel edge (e.g., polymer-containing buildup and copper-containing material).

Microelectronic device wafers may be reworked off-site or in-house. In-house reworking and recycling has the advantage of increasing the overall yield, decreasing the overall costs and reducing the cycle time between the diagnostic process and the rework.

In a removal application, a removal composition is contacted in any suitable manner to the rejected microelectronic device having material to be removed thereon, e.g., by spraying a removal composition on the surface of the device, by dipping (in a volume of a removal composition) of the device including the removable material, by contacting the device with another material, e.g., a pad, or fibrous sorbent applicator element, that has a removal composition absorbed thereon, by contacting the device including the material to be removed with a recirculating removal composition, or by any other suitable means, manner or technique, by which a removal composition is brought into removal contact with the material to be removed. The contacting conditions include a period of time and conditions sufficient to remove at the removable material. Further, batch or single wafer processing is contemplated herein. The removal process using a removal compositions may include a static clean, a dynamic clean, or sequential processing steps including dynamic cleaning, followed by static cleaning of the device in a removal composition, with the respective dynamic and static steps being carried out alternatingly and repetitively, in a cycle of such alternating steps.

The removal compositions may be used with a large variety of conventional cleaning tools, including Verteq single wafer megasonic Goldfinger, OnTrak systems DDS (double-sided scrubbers), Laurell spin-spray tools, SEZ single wafer spray rinse, Applied Materials Mirra-Mesa^{™} /Reflexion^{™}/Reflexion LK^{™}, and Megasonic batch wet bench systems.

As applied to microelectronic device manufacturing operations, removal compositions are usefully employed to remove at least one material selected from the group consisting of low-k dielectric layers, high-k dielectric materials, etch stop layers, metal stack materials, nitrides, silicides, oxides, ferroelectrics, barrier layer materials, photoresist, post-etch residue, ARC materials, polymer-containing buildup, doped regions, and combinations thereof from microelectronic device structures for reclaiming, reworking, recycling and/or reuse of said structures. In addition, it should be appreciated that removal compositions may be used during chemical mechanical polishing processes to accelerate the removal of CDO and other low-k dielectric materials or post-CMP processes to remove post-CMP residue material.

When removing at least one material selected from the group consisting of low-k dielectric layers, high-k dielectric materials, etch stop layers, metal stack materials, nitrides, silicides, oxides, ferroelectrics, barrier layers, photoresist, post-etch residue, ARC materials, polymer-containing buildup, doped regions, and combinations thereof from microelectronic device structures having same thereon, a removal composition typically is contacted with the device structure for a time of from about 30 seconds to about 60 minutes, more preferably about 75 sec to about 5 min, the preferred time being dependent on the thickness of the layer(s) to be removed, at temperature in a range of from about 20°C to about 90°C, preferably about 25°C to about 60°C, most preferably about 25°C to about 50°C. When etch stop layers are to be removed, the contacting time may be in a range of from about 5 minutes to about 3 hours at temperature in a range of from about 25°C to about 80°, depending on the thickness of the etch stop layer. Such contacting times and temperatures are illustrative, and any other suitable time and temperature conditions may be employed that are efficacious to substantially remove the material(s) from the device structure, within the broad practice of the invention.

Following the achievement of the desired removal action, the removal composition is readily removed from the microelectronic device to which it has previously been applied, e.g., by rinse, wash, drying, or other removal step(s), as may be desired and efficacious in a given end use application of the compositions disclosed herein. For example, the microelectronic device may be rinsed with deionized water. In addition, the microelectronic device may be dried with nitrogen gas, isopropanol, or SEZ (spin process technology).

When used, dense fluids may be applied at suitable elevated pressures, e.g., in a pressurized contacting chamber to which the SCF-based composition is supplied at suitable volumetric rate and amount to effect the desired contacting operation, preferably in a range of from about 1,500 to about 4,500 psi, preferably in a range of from about 3,000 to about 4,500 psi. Typical contacting times in a range of from about 1 minute to about 30 minutes and a temperature of from about 35°C to about 75°C, preferably in a range of from about 60°C to about 75°C, although greater or lesser contacting durations and temperatures may be advantageously employed in the broad practice of the present invention, where warranted. The removal process using the dense fluid compositions may include a static soak, a dynamic contacting mode, or sequential processing steps including dynamic flow, followed by a static soak, with the respective dynamic flow and static soak steps being carried out alternatingly and repetitively, in a cycle of such alternating steps.

Removal compositions may be monitored and controlled using statistical process controls (SPC) during contact of the compositions with the rejected microelectronic device structures. For example, the SPC of the removal composition bath may be monitored and several inputs controlled, including temperature of the bath, pH of the bath, concentration of the major components of the bath, concentration of the byproducts, and feed chemical purity. Preferably, the removal composition is monitored using in-line monitoring, wherein in-line sampling equipment may be communicatively coupled with standard analytical tools to monitor bath weight loss (which is an indication of water and/or amine loss), fluoride concentration, H₂O₂ concentration, pH, etc. By monitoring and/or controlling at least one of these parameters, the life of the removal composition bath may be extended, which maximizes process efficiency. The purpose of the SPC is to maintain a substantial steady state of several parameters of the removal composition as processing occurs over time, as readily determined by one skilled in the art.

For example, the removal composition may be sampled, manually and/or automatically, and the concentration of a component in the removal composition may be analyzed, using standard analytical techniques, and compared to the initial concentration of said component in the removal composition. An aliquot of a solution of said component may be added, either manually and/or automatically, to the bath to boost the concentration of the component to initial levels, as readily determined by one skilled in the art. It should be appreciated that the maintenance of the concentration of several components in the removal composition is dependent on how much loading of material(s) to be removed has occurred in said composition. As more and more compounds are dissolved therein, the solubility of many active components will actually decrease and eventually fresh removal composition will be required.

Towards this end, the SPC relates in one aspect to a multicomponent fluid composition monitoring and compositional control system, in which a component analysis is effected by titration or other analytical procedure, for one or more components of interest, and a computational means then is employed to determine and responsively adjust the relative amount or proportion of the one or more components in the multicomponent fluid composition, in order to maintain a predetermined compositional character of the multicomponent fluid composition. The SPC system preferably comprises (i) an analyzer unit, constructed and arranged to monitor the concentration of one or more components of the multicomponent fluid using a real-time methodology, and (ii) a control unit constructed and arranged to compare the results of the analyzer unit to pre-programmed specifications and responsively control dispensing of the aforementioned one or more components into the multicomponent fluid as required to maintain a predetermined concentration of the aforementioned one or more components in the multicomponent fluid used in the fluid-using processing facility. In another aspect, an SPC process of monitoring and compositionally controlling a multicomponent fluid used in a processing facility is disclosed, such process including conducting a real-time component analysis of the multicomponent fluid by titration or other analytical procedure, for one or more components of interest, and computationally and responsively adjusting in real time the relative amount or proportion of the one or more components in the multicomponent fluid composition, to maintain a predetermined compositional character of the multicomponent fluid composition utilized in the fluid-using processing facility.

As an example, an SPC system for generating hydrogen peroxide at a point of use comprising a hydrogen peroxide-using processing facility may comprise an electrochemical cell constructed and arranged for generating hydrogen peroxide, and a hydrogen peroxide monitoring and concentration control assembly including a analysis unit, e.g., a Karl Fischer analysis unit, comprising means for sampling fluid from the electrochemical cell and analyzing same, wherein the hydrogen peroxide monitoring and concentration control assembly includes means for real-time determination of concentration of the hydrogen peroxide based on the analysis. The process for generating hydrogen peroxide at a point of use including a hydrogen peroxide-using processing facility includes generating hydrogen peroxide in an electrochemical cell, and monitoring hydrogen peroxide in an analysis unit, e.g., a Karl Fischer analysis unit, including sampling fluid from the electrochemical cell and analyzing same, and determining in real time the concentration of the hydrogen peroxide based on the analysis.

As another example, the control unit functions as a process controller and is used to accurately control the automatic replenishment of the solvent components, in particular water, guaranteeing optimum and stable processing over an extended period of time. Once the component analyzer determines the relative composition of the solvent system, the process controller can restore the system to the correct component ratio. Specific limits are pre-programmed into the process controller for the specific component(s) being targeted for analysis. The results from the component analyzer are compared to these specification limits and, if determined to be below the minimum specification value, amounts of the target component can be injected into the solvent solution to restore the required component ratio. By maintaining the component ratio of the solvent system within predetermined limits, the effective bath life of the solvent mixture can be extended. Accordingly, the SPC in another aspect relates to a means and method of in situ monitoring and H₂O injection of compositions used for the reclamation and/or reworking of rejected microelectronic device structures. Using the concentration analysis and solvent replenishment system to analyze the solution and adjust the water level, the bath life can be increased by at least 100%. This results in substantial savings in a) chemicals, b) downtime for chemical changes, and c) chemical disposal costs.

These and other SPC embodiments are disclosed in U.S. Patent Nos. 7,214,537 and 7,153,690, both in the name of Russell Stevens, et al., and both of which are hereby incorporated by reference in their entirety.

With regards to the analysis of HF in a removal composition, the analyzer unit of the SPC may include: (a) a combination of temperature, electrical conductivity, viscosity and ultrasonic propagation velocity values may be analyzed and used to calculate the concentration of HF (see, e.g., U.S. Patent No. 6,350,426 in the name of Sota et al.); (b) fluoride ion-selective electrodes; (c) spectrophotometry; (d) colorimetrically using boronic acid chemistry; and (e) spectrofluorometrically using boronic acid fluorophores (see, e.g., PCT/US2004/022717 filed June 28, 2004 in the name of University of Maryland Biotechnology Institute); to determine the concentration of fluoride in the removal composition. H₂O₂ monitoring techniques include iodometric or permanganate titrations, colorimetric processes such as the oxidation of titanium (IV) salt and the oxidation of cobalt (11) and bicarbonate in the presence of H₂O₂ to form a carbonato-cobaltate (III) complex, and the scopoletin procedure using horseradish-derived peroxidase.

Analysis units may include, but are not limited to, UV-Vis spectrophotometers, IR spectrometers, near IR spectrometers, fluorometers, atomic spectrometers including inductively coupled plasma spectrometers and atomic absorption spectrometers, titration units, electrochemical units and chromatographic units.

Surprisingly, the inventors discovered that the same microelectronic device structure may be reclaimed, for example, material(s) are removed to reclaim the substrate or to reclaim the substrate plus the layer(s) to be retained, multiple times. For example, the same substrate may be processed to deposit at least one material layer and subsequently reclaimed greater than or equal to two times, preferably greater than or equal to 5 times, more preferably greater than or equal to 10 times, and most preferably greater than or equal to 20 times, depending on the method and the material being deposited, said reclamation satisfies the reclamation requirements described herein each time. Importantly, the reclamation process preferably is a single step removal process (i.e., all of the material(s) to be removed are done so using a single composition in a single step) and preferably no post-reclamation planarization is needed prior to subsequent processing. That said, it should be appreciated by one skilled in the art that some deposition methods and some materials damage the substrate and as such, some planarization may be needed to successfully reclaim the substrate. Planarization will have the effect of limiting the number of times a substrate may be reclaimed.

It should be appreciated that a multiple step removal process wherein at least one step requires the use of at least one removal composition disclosed herein is contemplated. For example, the removal process may be a two step process wherein the first step includes contacting a microelectronic device having a substrate and at least one material to be removed with a removal composition described herein for sufficient time and under sufficient conditions (e.g., as disclosed herein) to remove said at least one material from the microelectronic device, and polishing the substrate to remove surface damage, wherein the polishing conditions are well known in the art.

In addition, the inventors surprisingly discovered that the same microelectronic device structure may be reworked, for example, photoresist and ARC material(s) are removed from the microelectronic device structure, upwards of ten times. For example, the same structure may be photolithographically processed and subsequently reworked to remove the erroneously positioned photoresist pattern greater than or equal to two times, preferably greater than or equal to five times, and most preferably, greater than or equal to ten times, wherein said rework does not substantially damage the layer(s) to be retained. In addition, the inventors surprisingly discovered that the backside and/or bevel edge of the microelectronic device structure may be readily cleaned, for example, polymer-containing buildup and/or metals are removed from the backside and/or bevel edge of the microelectronic device structure without resorting to the methods used in the art (e.g., physical polishing, dry plasma etching, combustion, etc.).

Further, the inventors surprisingly discovered that the potency of a bath of the removal compositions of the invention may last greater than or equal to two days, preferably greater than or equal to five days, and most preferably, greater than or equal to ten days, at temperature in a range from about room temperature to about 60°C. In other words, a ten-day old bath at temperature in a range from about room temperature to about 60°C may be used to successfully reclaim, rework, and/or clean (the backside and/or bevel edges) a microelectronic device structure, according to the requirements provided herein, assuming the bath is not "loaded" with material(s) to be removed. As defined herein, a "loaded" composition corresponds to a volume of removal composition that can no longer dissolve and/or delaminate at least one material(s) to be removed from the microelectronic device structure, as readily determined by one skilled in the art. A loaded removal composition can correspond to the undersaturation, saturation, or supersaturation of a particular material to be removed using the removal composition, the active component(s) in the composition, as well as byproducts thereof.

Another surprising discovery was the potency of the removal composition bath with use. An unloaded bath of the removal composition having a volume in a range from about 5 L to about 50 L, efficaciously removed the material(s) to be removed from greater than or equal to 50, preferably greater than or equal to 200, more preferably greater than or equal to 500, even more preferably greater than or equal to 1000, and most preferably greater than or equal to 2500 rejected microelectronic device structures having a 300 mm × 750 µm substrate, depending on the number of layers of material(s) that must be removed, as readily determined by one skilled in the art.

In a further aspect, an article comprising a microelectronic device is disclosed, wherein said microelectronic device comprises a microelectronic device structure or microelectronic device substrate that has been reclaimed, reworked, recycled and/or reused using the methods described herein, said method comprising contacting a microelectronic device structure with a removal composition for sufficient time and under sufficient conditions to substantially remove at least one material selected from the group consisting of low-k dielectric material, high-k dielectric materials, etch stop layers, metal stack materials, nitrides, silicides, oxides, ferroelectrics, barrier layer materials, photoresist, post-etch residue, ARC material, polymer-containing buildup, doped regions, and combinations thereof. The recycled or reused microelectronic device structure or microelectronic device substrate may subsequently comprise one or more layers deposited thereon, including at least one of a low-k dielectric layer, high-k dielectric material, etch stop layer, metal stack material, nitride layer, silicide layer, oxide layer, ferroelectric layer, barrier layer materials, doped regions, and combinations thereof, in a subsequent microelectronic device manufacturing process.

In still another aspect, an article is described, wherein said article comprises a reworked microelectronic device structure or reworked microelectronic device substrate and at least one additional material layer selected from the group consisting of low-k dielectric material, high-k dielectric materials, etch stop layers, metal stack materials, nitrides, silicides, oxides, ferroelectrics, barrier layer materials, photoresist, ARC material, doped regions, and combinations thereof, wherein the at least one additional material layer was deposited onto the microelectronic device structure or substrate subsequent to reworking. The article may further comprise an intermediate layer positioned between the microelectronic device structure or substrate and the at least one additional material layer.

In a further aspect, a method of manufacturing an article comprising a microelectronic device is disclosed, wherein said microelectronic device comprises a microelectronic device structure or microelectronic device substrate that has been reclaimed, reworked, recycled, and/or reused using the methods described herein, said method comprising contacting a microelectronic device structure with a removal composition for sufficient time and under sufficient conditions to substantially remove at least one material selected from the group consisting of low-k dielectric material, high-k dielectric materials, etch stop layers, metal stack materials, nitrides, silicides, oxides, ferroelectrics, barrier layer materials, photoresist, post-etch residue, ARC material, polymer-containing buildup, doped regions, and combinations thereof. The method of manufacturing the article may further comprise the deposition of one or more layers on the recycled or reused microelectronic device structure or microelectronic device substrate, wherein said one or more layers include at least one of a low-k dielectric layer, high-k dielectric material, etch stop layer, metal stack material, nitride layer, silicide layer, oxide layer, ferroelectric layer, barrier layer, doped region, and combinations thereof, in a subsequent microelectronic device manufacturing process.

In yet another aspect, the present invention relates to a method of cleaning the backside and/or bevel edge of a microelectronic device structure, said method comprising: positioning the structure in a tool that protects the front side of the structure using nitrogen gas and/or deionized water spray; and contacting the backside and/or bevel edge of the structure with a removal composition, wherein the removal composition substantially removes polymer-containing buildup from the backside and/or bevel edge of the microelectronic device substrate.

In still another aspect, a method of processing a microelectronic device using the compositions described herein is disclosed, whereby the temperature of the processing bath is decreased. Presently, most facilities process microelectronic devices at higher bath temperatures so to minimize the processing time. Unfortunately, the higher bath temperatures result in an increase in water and/or HF evaporation, and hence a decrease in the efficiency of the bath. Specifically, this method relates to the lowering of the temperature of the removal composition during material removal, e.g., immersion, spraying, etc., followed by a hot rinse with solvent, water, or a solvent/water mixture to remove unwanted residue buildup that occurred during the material removal process. Following the hot rinse, the wafer may be optionally: rinsed with additional solvent (e.g., at room temperature); dried, (e.g., with an IPA vapor dry); polished; and/or otherwise prepared for additional processing, e.g., deposition of new material layers, as readily determined by one skilled in the art. Preferably, the hot rinse solvent comprises water and/or an organic solvent, e.g., methanol, ethanol, isopropanol, ethylene glycol, propylene glycol, diethylene glycol butyl ether, dipropylene glycol methyl ether. In a further embodiment, megasonics or agitation may be used in conjunction with the hot rinse to assist in the removal of the residue buildup.

For example, a method for removing material from a microelectronic device having same thereon may comprise:
(a) contacting the microelectronic device with a removal composition for sufficient time at a first temperature to substantially remove at least one material from the microelectronic device; and
(b) contacting the microelectronic device with a rinse composition for sufficient time at a second temperature to substantially remove residue buildup from the microelectronic device,
wherein the difference between the first temperature and the second temperature is in a range from about 40°C to about 90°C. For example, the first temperature may be in a range from about 5°C to about 30°C and the second temperature may be in a range from about 45°C to about 99°C. Accordingly, the first temperature is lower than the second temperature. Applicable times for material removal are in a range from about I minute to about 60 minutes, preferably about 1 minute to about 30 minutes, and most preferably about I minute to about 10 minutes, the preferred time being dependent on the thickness of the layer(s) to be removed. Applicable times for the hot rinse are in a range from about I minute to about 60 minutes, preferably about 1 minute to about 30 minutes, and most preferably about I minute to about 10 minutes, the preferred time being dependent on the extent of residue buildup on the microelectronic device. As introduced, megasonics or agitation may be used during the hot rinse to assist in the removal of the residue buildup. Preferably, the hot rinse composition comprises water. The hot rinse preferably uses fresh rinse composition every time although it is contemplated that the rinse composition may be recirculated, if necessary. The microelectronic devices may be processed as single wafers or as a batch and the hot rinse process may be repeated more than once, in part (e.g., just part (a) or just part (b)) or in whole (e.g., part (a) and part (b)).

An alternative to lowering the bath temperature to minimize evaporation is to include a layer of material(s) on the bath to minimize evaporative effects. Notably, the layer has to include a material or materials that will not substantially dissolve or intermingle in the compositions of the bath. For example, TEFLON@ coated materials or TEFLON@ materials that float on the surface of the bath, i.e., are less dense than the bath, may be used to completely cover the bath and slow evaporation, thereby increasing the bath life. TEFLON@ coated materials may include hollow, lightweight shapes such as spheres and other polygonal shapes. The shapes may be symmetrical or unsymmetrical. Alternatively, the TEFLON@ coated materials may be a shape that is designed to easily fit over the bath, e.g., a floating lid.

In a further aspect, a wet bench tool for processing wafers is disclosed, said wet bench tool comprising at least three baths, wherein the first bath comprises a removal composition, the second bath comprises a rinse composition, and the third bath comprises a neutralizing bath for use subsequent to the removal composition bath but prior to the rinse bath, said bath being useful for neutralizing the high fluoride content of the removal composition that remains on the device wafer following immersion therein. As such, in yet another aspect, a method of substantially removing material(s) from the microelectronic device structure using a removal composition, neutralizing the wafer surface using a buffer rinse step and rinsing the neutralized wafer with water is disclosed. In a preferred embodiment, the present aspect relates to a method of removing at least one material from a microelectronic device structure having said material(s) thereon, said method comprising:
contacting the microelectronic device with a removal composition for sufficient time to substantially remove at least one material from the microelectronic device;
contacting the microelectronic device having removal composition thereon with a neutralizing composition to neutralize the removal composition on the microelectronic device; and
rinsing the microelectronic device having neutralized removal composition thereon with a rinsing solution to remove the neutralized removal composition therefrom,
   wherein the material(s) are selected from the group consisting post-etch residue, low-k dielectric, a high-k dielectric, an etch stop material, a metal stack material, a barrier layer material, a ferroelectric, a silicide, a nitride, an oxide, photoresist, bottom anti-reflective coating (BARC), sacrificial anti-reflective coating (SARC), polymer-containing buildup, miscellaneous materials, doped regions, and combinations thereof. Preferably, the neutralizing compositions include at least one buffering species wherein the pH of the neutralized removal composition is in a range from about 5 to about 9, more preferably in a range from about 6 to about 8, and most preferably about 7. Buffering species contemplated herein include, but are not limited to, commercial color-coded buffer solutions or customized solutions including bases such as hydroxides, carbonates, phosphates, diphosphates, etc., and base/salt mixtures. Preferably, the rinsing solution comprises water.

In yet another aspect, a multiple step removal process to substantially eliminate pitting of the microelectronic device substrate during reclamation processing is disclosed. The multiple step process includes at least one step to remove metal(s) and at least another step to remove non-metal layers (e.g., post-etch residue, low-k dielectrics, high-k dielectrics, etch stop materials, ferroelectrics, silicides, nitrides, oxides, photoresist, bottom anti-reflective coating (BARC), sacrificial anti-reflective coating (SARC), polymer-containing buildup, miscellaneous materials, doped regions, and combinations thereof) and barrier layer materials. For example, the step to remove metal(s) may include contacting the microelectronic device structure with a first composition including at least one oxidizing agent, at least one chelating agent, and optionally water to yield a microelectronic device structure that is substantially devoid of metal(s). The step to remove non-metal layer(s) and barrier layer materials may include contacting the microelectronic device structure that is substantially devoid of metal(s) with a removal composition of the invention, e.g., the removal compositions of the second aspect or the fifth aspect and any other removal composition that is devoid of oxidizing agent, to yield a microelectronic device substrate. It should be appreciated that a rinse step may be incorporated between the step to remove metal(s) and the step to remove non-metal layer(s) and barrier layer materials. Further, it should be appreciated that the aforementioned neutralizing bath may be incorporated into the process subsequent to the step to remove non-metal layer(s) and barrier layer materials to neutralize the high fluoride content of the removal composition that remains on the device wafer following immersion therein. Regardless of whether the neutralizing bath is used or not, the microelectronic device substrate may be rinsed, dried, and further processed for recycling and/or reuse as described herein. Contacting conditions for each of the steps of the process are described herein. For example, the first removal composition may be used to remove copper and may include HEDP and H₂O₂ and the second removal composition may be used to remove dielectric and barrier layer material and may include a composition described in the second aspect or fifth aspect herein.

The range of weight percent ratios of the components in the first composition is about 0.1:1 to about 5:1 chelating agent(s) relative to oxidant(s), preferably about 0.33:1 to about 3:1, and most preferably about 0.6:1 to about 2:1.

In still another aspect, a kit for the multiple step removal process is disclosed, said kit including one or more containers, including the first composition, the removal composition, and/or the neutralizing composition. The kit may include instructions on how to use the compositions of the multiple step removal process to substantially eliminate pitting of the microelectronic device substrate during reclamation processing. The first composition, the removal composition and/or the neutralizing composition may be provided premixed in their own individual containers. It is also contemplated that the components of the first composition may be provided in one or more containers for mixing at the point of use (with each other and/or water) to make the first composition, that the components of the removal composition may be provided in one or more containers for mixing at the point of use (with each other and/or water) to make the removal composition, and/or the components of the neutralizing composition may be provided in one or more containers for mixing at the point of use (with each other and/or water) to make the neutralizing composition. The containers of the kit should be chemically rated to store and dispense the component(s) contained therein. For example, the containers of the kit may be NOWPak® containers (Advanced Technology Materials, Inc., Danbury, Conn., USA) as described herein.

Following processing, the compositions described herein may be further processed to lower the chemical oxygen demand (COD) of the waste water stream in the fabrication facility. For example, mixed aqueous-organic formulations containing both organic solvents and inorganic biotoxic compounds such as fluorides may be treated with (1) carbon, preferably a polyvinylidene chloride (PVDC) monolith carbon having micropores less than 1 nm wide, which will "scrub" the organic solvent from the composition, (2) a metal carbonate, such as alkali or alkaline earth metal carbonate, which can react with the fluoride ions and neutralize any acid present, and/or (3) a calcium silicate, such as Ca₃SiO₅·Ca₂SiO₄·xH₂O, which can react with the fluoride ions and neutralize any acid present. The treatments may be sequential or in a one-step mixed bed approach. The waste water stream of the fab should be exposed to the treatment(s) until the COD is lowered to promulgated acceptable levels.

Although the processes described herein efficaciously remove the material(s) to be removed, the processes cannot smooth out defects such as pits and scratches which were present on the original substrate. Accordingly, the wafer may still need to be subjected to planarization to remove said imperfections. Typically, about 20 to 40 microns of substrate are lost to imperfection removal using planarization, which can be an unacceptable loss to many manufacturers because it limits the number of times the substrate may be reused/recycled.

Accordingly, in another aspect, the substrate may be perfected prior to the deposition of any layer(s), wherein the substrate may be an original substrate (with or without epitaxial Si) or a reclaimed, reworked, recycled and/or reused substrate (with or without epitaxial Si). Accordingly, the methods described herein may further include the exposure of a XeF₂ vapor phase etchant to the substrate to remove pits and scratches present thereon. Said exposure may occur prior to the deposition of any layer(s) on the original substrate (i.e., before deposition of any material(s) and hence before the need to reclaim), or before the deposition of layer(s) onto the reclaimed substrate. XeF₂ reacts with silicon according to the following reaction, whereby the etching reaction occurs via the formation of volatile SiF₄ gas, which spontaneously leaves the surface of the substrate:

XeF₂(g)+Si(s)⇆Xe(g)+SiF₂(s)

XeF₂(g)+SiF₂(s)→Xe(g)+SiF₄(g)

XeF₂ is a solid that sublimes at room temperature with a vapor pressure of ~4 Torr. It reacts with silicon to form volatile SiF₄ and inert Xe by-products, but is extremely selective with respect to SiO₂ and other dielectrics. In one embodiment, the perfecting of the substrate includes the reaction of XeF₂ with the substrate in the presence of additional activation energy, i.e., plasma or thermal heating. In another embodiment, no additional activation energy is necessary

There are several ways to deliver the XeF₂ compound to the vacuum chamber for cleaning: via the stagnant mode, the continuous mode, and/or the direct introduction mode, as introduced in U.S. Patent Application No. 10/973,673 in the name of Frank Dimeo et al., which is hereby incorporated by reference.

In the stagnant mode, a crucible or source container with the compound inside can be attached to the chamber with valve between them. During cleaning this valve can be open (manual or remotely) and the XeF₂ vapor allowed to fill the chamber until a certain pressure is attained. The vacuum chamber can then be sealed and the XeF₂ allowed to react for a period of time. The vacuum chamber would then be evacuated and the process repeated as needed. The temperature, pressure, length of time and number of repeats are experimental parameters easily determined by one skilled in the art. For example, initial ranges might include a pressure of 0.5 torr for a time of 2 minutes which can be repeated 5 times. Additionally, the pressure in the source during etching should be monitored. A gradual pressure increase will be observed as the reaction proceeds, and should plateau when the reaction has run its course. The crucible may be moderately heated to increase the sublimation rate or sublimation pressure of the XeF₂.

In the continuous mode, an inert carrier gas may be arranged to flow continuously over the XeF₂ in the crucible, thus delivering a steady stream of XeF₂ to the vacuum chamber. The flow rate of the carrier gas, temperature of the crucible, and time of etching are experimental parameters readily determined by one skilled in the art.

In the direct introduction mode, pre measured amounts of XeF₂ solid material in the chamber is placed in the vacuum chamber. These solids sublimate until they are completely exhausted. The amount of material and time required for cleaning are readily determined by one skilled in the art. Likewise, methods for mechanical dispensing are readily engineered and determinable by one skilled in the art.

In yet another aspect, a method of reclaiming, reworking, reusing and/or recycling a DNA chip, also referred to as a DNA microarray is disclosed, using the removal compositions described herein. DNA chips typically are typically produced on glass substrates and nucleic acids are deposited thereon using photolithographic techniques. As such, there will be occasions where the DNA chip is rejected and would otherwise be scrapped if it were not reclaimed, reworked, reused and/or recycled.

The features and advantages of the invention are more fully shown by the illustrative examples discussed below.

### Example 1

To make the removal compositions compliant with national and international environmental standards, diethylene glycol butyl ether components, which are HAP's, of said removal compositions were substituted with solvents not on the HAP list, specifically propylene glycol, dipropylene glycol, and ethers thereof. Each formulation includes 20.1 wt. % HF, 2.2 wt. % sulfolane, 21.7 wt. % non-HAP list solvent, and 56 wt. % water, based on the total weight of the composition. The compositions are shown below in Table I with the specific non-HAP list solvent. In each case, a blanketed wafer including Black Diamond (hereinafter BD, thickness approximately 6,500 Å) or CORAL (thickness approximately 22,000 Å) was immersed in a volume of the composition for 5 min at 50°C (unless noted otherwise) and visually inspected.

**Table 1: Chemical formulations including non-HAP list organic solvents**

| non-HAP list organic solvent | Observations |
|---|---|
| dipropylene glycol methyl ether (formulation RR) | BD: not clean, some residues CORAL: not clean, some residues |
| ethyl lactate (formulation SS) | BD: clean, some residue removed by water rinse CORAL: not clean, some residues |
| dipropylene glycol butyl ether (formulation TT) | BD: not clean, some residues CORAL: not clean, some residues binary phases |
| dipropylene glycol propyl ether (formulation UU) | BD at room temperature: film delaminated in 1 min and dissolved in 10 min, surface clean BD at 50°C: film delaminated and dissolved in 3 min, surface clean CORAL at room temperature: film delaminated and dissolved in 4 min CORAL at 50°C: film delaminated and dissolved in 1 min, surface clean |
| propylene glycol butyl ether (formulation VV) | BD: not clean, some residues CORAL not clean, some residues binary phases |
| propylene glycol (formulation WW) | BD: not clean, some residues CORAL: film delaminated and dissolved in I min, residue on surface removed by water rinse and N₂ blow |
| diethylene glycol butyl ether (Formulation EE) | BD at room temperature: film delaminated in 1 min and dissolved in 4 min, surface clean BD at 50°C: film delaminated and dissolved in 2 min, surface clean CORAL at room temperature: film delaminated and dissolved in 2 min CORAL at 50°C: film delaminated and dissolved in 1 min, surface clean |

The etching results indicate that formulation UU including dipropylene glycol propyl ether displayed equivalent efficacy with formulation EE for removing low-k dielectric materials such as Black Diamond and CORAL.

### Example 2

It is known that removal compositions including oxidizing agent(s), e.g., H₂O₂, can be relatively unstable in the presence of certain organic components. Accordingly, it is often necessary to add the oxidizing agent to the remainder of the components at the point of use, which can be inconvenient to the user. As such, oxidizing agents other than H₂O₂, that will be more stable in the removal compositions of the invention, were experimented with to determine the efficacy of removal of copper having a thickness of 16,000 Å from a blanketed wafer having same thereon, wherein the wafer is immersed in the solutions in Table 2 at room temperature or 40°C and visually inspected.

**Table 2: Removal of Copper using various oxidizing agents**

| oxidizing agent | wt. % in H₂O | temperature | observations |
|---|---|---|---|
| H₂O₂ | 5 | room temp | not clear after 20 min |
| ammonium persulfate | 5 | room temp | clear after 5.5 min |
| oxone | 5 | room temp | clear after 12 min |
| H₂O₂ | 5 | 40°C | not clear after 10 min |
| ammonium persulfate | 5 | 40°C | clear after 3 min |
| oxone | 5 | 40°C | not performed |

It can be seen that the order of etch rate efficacy is H₂O₂ < oxone < ammonium persulfate. Accordingly, other oxidizing agents, especially the persulfates and peroxomonosulfates may be used instead of H₂O₂ (or with H₂O₂) depending on the needs of the user as well as the impact of the various oxidizing agents on the material(s) on the microelectronic device structure.

### Example 3

Blanketed polysilicon was immersed in the green formulations (GI-G4) of the invention and it was determined that the etch rate of polysilicon in the green formulations was about 0.5 Å min⁻¹ compared to the 0.9 Å min⁻¹ observed with formulation CC (i.e., the non-green formulation). Additionally, it is noted that the COD for the green formulations is about 60 times lower than the COD for formulation CC.

### Example 4

Current shelf-life (bath-life) testing has been performed which demonstrate that a first composition (e.g., for the multiple step removal process to substantially eliminate pitting) including HEDP and hydrogen peroxide is stable at 60°C for over 3 weeks. The H₂O₂ concentration was tested weekly and after 3 weeks over 92% H₂O₂ remains, suggesting that the first composition is very stable and can be manufactured and shipped as one solution.

### Example 5

Formulation P1 including HF 20.1 wt%; Butyl carbitol 21.7 wt%; Sulfolane 2.2 wt%; H₂O₂ 5 wt%; CDTA 0.15 wt%; HCl (conc) 2 wt.% and Water 48.85 wt.% was made and a pre-strip substrate, consisting of about 15,000 Å of electroplated Cu over a layer of silicate glass coated on a Si wafer, was immersed therein for 10 min at 40°C. In addition, a pre-strip substrate was immersed in Formulation RR under the same conditions for comparison purposes. Subsequent to immersion in the formulations, the wafers were rinsed with water and dried. Post-cleaning analysis was carried out using a scanning electron microscope (SEM).

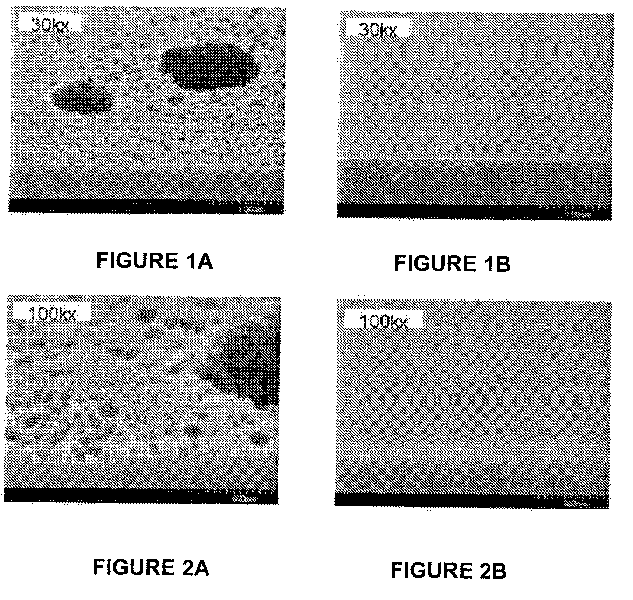

Referring to Figures 1A and 2A (formulation RR) relative to 1B and 2B (formulation P1), it can be seen that the pitting of the Si wafer is substantially eliminated when the formulation (P1) includes HCl (Figures 1B and 2B) relative to the formulation (RR) that does not include HCl (Figures 1A and 2A). Accordingly, the inclusion of HCl in the removal compositions disclosed herein is a viable option to substantially eliminate pitting of the microelectronic device substrate in a one-step process.

### Example 6

The multiple step removal process to substantially eliminate pitting is demonstrated in this example. A wafer consisting of 16,000 Å Cu, 250 Å Ta, and 5,000 Å USG was immersed in the first composition, which included 40 wt.% H₂O₂ (50%), 30 wt.% HEDP (60%) and the remainder water, at room temperature for 10 min, followed by immersion in formulation CC at room temperature for 10 min. For comparison purposes, the same wafer was immersed in formulation G3 at room temperature for 10 min. Post-cleaning analysis was carried out using a scanning electron microscope (SEM). Notably, the micrographs show that the wafer has similar surface roughness after being processed in formulation G3 versus the two step process including formulation CC.

### Example 7

Individual silicon wafers having blanketed films of AURORA, BLACK DIAMOND, CORAL, fluorinated silicate glass (FSG), ultra low-k (ULK), TEOS, thermal oxide (ThOx), silicon nitride (SiN), titanium nitride (TiN), tantalum nitride (TaN), cobalt silicide (CoSi), nickel silicide (NiSi), tungsten silicide (WSi), W, Cu, Al, Ti, Ta, photoresist, SiCN, and SiC were immersed in containers including clean formulation CC or RR and the etch rate determined at room temperature and 60°C. The results are provided in Table 3 below.

| Material | Etch rate in formulation CC | | Etch rate in formulation RR | |
|---|---|---|---|---|
| | room temperature | 60°C | room temperature | 60°C |
| AURORA | > 10,000 | >20,000 | >3,000 | >8,000 |
| BLACK DIAMOND | > 10,000 | >20,000 | >2,000 | >3,000 |
| CORAL | > 10,000 | >20,000 | > 10,000 | > 15,000 |
| FSG | > 10,000 | >20,000 | >13,000 | >20,000 |
| ULK | > 10,000 | >20,000 | >2,000 | >3,000 |
| TEOS | > 10,000 | >25,000 | >5,000 | >11,000 |
| ThOx | >5,000 | >10,000 | >2,000 | >4,000 |
| SiN | 200 | 800 | 200 | 800 |
| TiN | 80 | 400 | 100 | 600 |
| TaN | 20 | 60 | >600 | >2,500 |
| CoSi | >1,500 | >5,000 | >5,000 | >6,000 |
| NiSi | >200 | >1,000 | 100 | 500 |
| WSi | 0 | 0 | >800 | >1,500 |
| W | N/A | N/A | 10 | >400 |
| Cu | 0 | 0 | >28,000 | >34,000 |
| A1 | <1,000 | >5,000 | >4,000 | > 14,000 |
| Ti | N/A | N/A | >2,000 | >5,000 |
| Ta | 150 | >2,500 | >2,000 | >400 |
| photoresist | yes | yes | unknown | unknown |
| SiCN | 0.5 | 2 | 0.5 | 2 |
| SiC | 0 | 0 | 0 | 0 |

Accordingly, while the invention has been described herein in reference to specific aspects, features and illustrative embodiments of the invention, it will be appreciated that the utility of the invention is not thus limited, but rather extends to and encompasses numerous other aspects, features, and embodiments. Accordingly, the claims hereafter set forth are intended to be correspondingly broadly construed, as including all such aspects, features, and embodiments, within their spirit and scope.

## Claims

1. A removal composition comprising at least one etchant, at least one surfactant, optionally at least one organic solvent, optionally at least one chelating agent, optionally at least one oxidizing agent, optionally at least one chloride source and optionally water, wherein said removal composition is suitable for removing at least one material selected from the group consisting of post-etch residue, low-k dielectric, high-k dielectric, etch stop material, metal stack material, barrier layer material, ferroelectric material, silicide material, nitride material, oxide material, photoresist, bottom anti-reflective coating (BARC), sacrificial anti-reflective coating (SARC), polymer-containing buildup, miscellaneous materials, doped regions, and combinations thereof from a microelectronic device structure having said material thereon.

2. The removal composition of claim 1, comprising said at least one organic solvent and water.

3. The removal composition of claim 1, comprising at least one chelating agent, at least one oxidizing agent, at least one chloride source, and water.

4. The removal composition of claim 3, further comprising at least one organic solvent.

5. The removal composition of any of claims 1-4, wherein the at least one etchant comprises HF,
wherein the at least one surfactant comprises a species selected from the group consisting of fluoroalkyl surfactant, ethoxylated fluorosurfactant, polyethylene glycol, polypropylene glycol, polyethylene glycol ether, polypropylene glycol ether, carboxylic acid salt, dodecylbenzenesulfonic acid and salts thereof, polyacrylate polymer, dinonylphenyl polyoxyethylene, silicone polymer, modified silicone polymer, acetylenic diol, modified acetylenic diol, alkylammonium salt, modified alkylammonium salt, alkylphenol polyglycidol ether, sodium alkyl sulfate, ammonium alkyl sulfate, alkyl (C₁₀-C₁₈) carboxylic acid ammonium salt, sodium sulfosuccinate and esters thereof, alkyl (C₁₀-C₁₈) sulfonic acid sodium salt, di-anionic sulfonate surfactant, cetyltrimethylammonium bromide, cetyltrimethylammonium hydrogen sulfate, ammonium carboxylate, ammonium sulfate, amine oxide, N-dodecyl-N,N-dimethylbetaine, betaine, sulfobetaine, alkylammoniopropyl sulfate, polyethylene glycol (PEG), polyethylene oxide (PEO), polyvinyl pyrrolidone (PVP), hydroxyethylcellulose (HEC), acrylamide polymers, poly(acrylic acid), carboxymethylcellulose (CMC), sodium carboxymethylcellulose (Na CMC), hydroxypropylmethylcellulose, polyvinylpyrrolidone K30, latex powder, ethylcellulose polymer, propylcellulose polymer, cellulose ether, water soluble resin, and combinations thereof,
wherein the at least one organic solvent comprises a species selected from the group consisting of alcohols, ethers, pyrrolidinones, glycols, carboxylic acids, glycol ethers, amines, ketones, aldehydes, alkanes, alkenes, alkynes, amides, sulfur-containing solvents, sulfones, and combinations thereof, with the proviso that the glycols and glycol ethers do not include an ethylene group,
wherein the at least one chelating agent comprises a species selected from the group consisting of acetylacetonate, 1,1,1-trifluoro-2,4-pentanedione, 1,1,1,5,5,5-hexafluoro-2,4-pentanedione, formate, acetate, bis(trimethylsilylamide) tetramer, glycine, serine, proline, leucine, alanine, asparagine, aspartic acid, glutamine, valine, lysine, citric acid, acetic acid, maleic acid, oxalic acid, malonic acid, succinic acid, phosphonic acid, hydroxyethylidene diphosphonic acid (HEDP), 1-hydroxyethane-1,1-diphosphonic acid, nitrilo-tris(methylenephosphonic acid), nitrilotriacetic acid, iminodiacetic acid, etidronic acid, ethylenediamine, ethylenediaminetetraacetic acid (EDTA), (1,2-cyclohexylenedinitrilo)tetraacetic acid (CDTA), uric acid, tetraglyme, pentamethyldiethylenetriamine (PMDETA), 1,3,5-triazine-2,4,6-thithiol trisodium salt solution, 1,3,5-triazine-2,4,6-thithiol triammonium salt solution, sodium diethyldithiocarbamate, disubstituted dithiocarbamates, ammonium sulfate, monoethanolamine (MEA), Dequest 2000, Dequest 2010, Dequest 2060s, diethylenetriamine pentaacetic acid, propylenediamine tetraacetic acid, 2-hydroxypyridine 1-oxide, ethylendiamine disuccinic acid, sodium triphosphate penta basic, and combinations thereof,
wherein the at least one oxidizing agent comprises hydrogen peroxide, and
wherein the at least one chloride source comprises hydrochloric acid, alkali metal chlorides, alkaline earth metal chlorides, ammonium chloride, and combinations thereof.

6. The removal composition of claim 2, wherein the composition comprises HF, at least one sulfone, at least one sodium ethylhexyl sulfate surfactant, and water.

7. The removal composition of claim 3, wherein the composition comprises HF, HCl, at least one sodium ethylhexyl sulfate surfactant, at least one phosphonic acid derivative, H₂O₂, and water.

8. The removal composition of claim 7, further comprising at least one sulfone compound.

9. The removal composition of any of claims 1-4, wherein the composition further comprises material residue selected from the group consisting of post-etch residue, low-k dielectric material residue, high-k dielectric material residue, barrier layer material residue, ferroelectric residue, nitride residue, silicide residue, oxide residue, polymer-containing buildup residue, ARC material residue, doped region residue, miscellaneous material residue, and combinations thereof.

10. A method of recycling a microelectronic device structure, said method comprising:
contacting a microelectronic device structure comprising a microelectronic device substrate and at least one removable material selected from the group consisting of post-etch residue, low-k dielectric, high-k dielectric, etch stop material, metal stack material, barrier layer material, ferroelectric material, silicide material, nitride material, oxide material, photoresist, bottom anti-reflective coating (BARC), sacrificial anti-reflective coating (SARC), polymer-containing buildup, miscellaneous materials, doped regions, and combinations thereof, with the removal composition of any of claims 1-4 for sufficient time and under sufficient conditions to substantially remove at least one material from the microelectronic device structure to yield a recyclable or reusable microelectronic device substrate.

11. The method of claim 10, wherein said contacting to remove at least one material(s) from the microelectronic device substrate occurs in a single step.

12. The method of claim 10, further comprising depositing at least one depositable material selected from the group consisting of low-k dielectric, a high-k dielectric, etch stop material, metal stack material, barrier layer material, ferroelectric material, silicide material, nitride material, oxide material, photoresist, bottom anti-reflective coating (BARC), sacrificial anti-reflective coating (SARC), miscellaneous materials, and combinations thereof, on the reclaimed substrate.

13. The method of claim 10, wherein said contacting is carried out at conditions selected from the group consisting of time in a range from about 30 sec to 60 min; temperature in a range from about 20°C to about 90°C; and combinations thereof.

14. The method of claim 10, wherein the microelectronic device structure comprises an article selected from the group consisting of semiconductor substrates, solar cells (photovoltaics), flat panel displays, and microelectromechanical systems (MEMS).

15. The method of claim 10, wherein the front side of the structure is protected from contact with the removal composition.

16. A method of recycling a microelectronic device structure, said method comprising:
contacting a microelectronic device structure comprising a microelectronic device substrate and at least two removable materials selected from the group consisting of post-etch residue, low-k dielectric, high-k dielectric, etch stop material, metal stack material, barrier layer material, ferroelectric material, silicide material, nitride material, oxide material, photoresist, bottom anti-reflective coating (BARC), sacrificial anti-reflective coating (SARC), polymer-containing buildup, miscellaneous materials, doped regions, and combinations thereof, with a first removal composition for sufficient time and under sufficient conditions to substantially remove at least a first material from the microelectronic device structure, and
contacting the structure with a second removal composition according to claim 2 for sufficient time and under sufficient conditions to substantially remove at least a second material from the microelectronic device structure to yield a recyclable or reusable microelectronic device substrate.

17. The method of claim 16, wherein the first removal composition comprises at least one oxidizing agent, at least one chelating agent, and optionally water.

18. The method of claim 16, wherein the first material comprises a metal and wherein the second material comprises low-k dielectric material.
